# EUROPEAN PATENT APPLICATION

(11) **EP 3 892 664 A1**
(43) Date of publication of application: **13.10.2021**
(21) Application number: 19891889.8
(22) Date of filing: 04.09.2019
(51) Int. Cl.: C08G 61/12, H01L 51/50, H05B 33/10

(54) **PRODUCTION METHOD FOR POLYMER COMPOUND**

(30) Priority: 06.12.2018 JP 2018229431
(71) Applicant: Sumitomo Chemical Company, Limited, Tokyo 104-8260 (JP)
(72) Inventor: SAKAKIBARA, Ken, Ibaraki 300-3294 (JP); SHIRATORI, Mio, Tsukuba-shi, Ibaraki 300-3294 (JP)
(74) Representative: J A Kemp LLP
(86) International application number: PCT/JP2019/034749
(87) International publication number: WO 2020/115971

(57) **Abstract**

To provide a polymer compound production method which is capable of improving yield while lowering the dispersity of the molecular weight.

A method of producing a polymer compound A containing a constitutional unit (1-2) having a group obtained by removing one or more hydrogen atoms present on Ar¹ from a compound represented by the formula [1-2], comprising
a first step of separating high molecular weight components contained in a polymer compound B, by a fractionation precipitation method, from the polymer compound B containing a constitutional unit (1-1) having a group obtained by removing one or more hydrogen atoms present on Ar¹ from a compound represented by the formula [1-1], to obtain a polymer compound C composed of the high molecular weight components, and
a second step of converting the above-described constitutional unit (1-1) contained in the above-described polymer compound C obtained by the above-described first step into the above-described constitutional unit (1-2), to obtain the above-described polymer compound A: 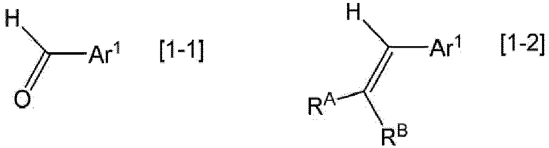 [wherein, Ar¹, R^{A} and R^{B} are as shown in the specification].

## Description

### Technical Field

The present invention relates to a production method of a polymer compound.

### Background Art

A polymer compound used in an organic electroluminescent device contains a large amount of low molecular weight components that are considered to be the cause for deterioration of the organic electroluminescent device when the value of the molecular weight dispersity (Mw/Mn) is large. The above-described polymer compound can be synthesized, for example, by polycondensation in the presence of a transition metal complex, however, the polymer compound obtained by polycondensation has theoretically a dispersity of 2, and additionally, the dispersity of the actually-resulting polymer compound is higher than 2 due to side reactions occurring during the polycondensation. For this reason, a method in which a polymer compound as a target substance is synthesized, then, low molecular weight components in the polymer compound are removed, to lower the dispersity of the molecular weight of the polymer compound has been developed (Patent Document 1).

### Prior Art Document

### Patent Document

[Patent Document 1] Japanese Translation of International Patent Application Publication (JP-T) No. 2012-503684

### Summary of the Invention

### Problem to be Solved by the Invention

However, in the above-described method, the yield of the polymer compound lowers in removing low molecular weight components.

Then, the present invention has an object of providing a polymer compound production method which is capable of improving yield while decreasing the dispersity of the molecular weight.

### Means for Solving the Problem

The present invention provides the following [1] to [8].
[1] A method of producing a polymer compound A containing a constitutional unit (1-2) having a group obtained by removing one or more hydrogen atoms present on Ar¹ from a compound represented by the formula [1-2], comprising
   a first step of separating high molecular weight components contained in a polymer compound B, by a fractionation precipitation method, from the polymer compound B containing a constitutional unit (1-1) having a group obtained by removing one or more hydrogen atoms present on Ar¹ from a compound represented by the formula [1-1], to obtain a polymer compound C composed of the high molecular weight components, and
   a second step of converting the above-described constitutional unit (1-1) contained in the above-described polymer compound C obtained by the above-described first step into the above-described constitutional unit (1-2), to obtain the above-described polymer compound A: 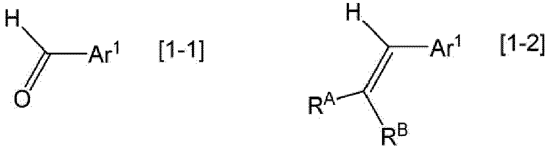 [wherein,
      Ar¹ represents an aryl group optionally having a substituent or a monovalent heterocyclic group optionally having a substituent.
      R^{A} and R^{B} each independently represent a hydrogen atom, an alkyl group, a cycloalkyl group, an aryl group or a monovalent heterocyclic group, and these groups optionally have a substituent.].
[2] The production method according to [1], wherein the above-described polymer compound B, a good solvent for the above-described polymer compound B and a poor solvent for the above-described polymer compound B are used in the above-described fractionation precipitation method.
[3] The production method according to [1] or [2], wherein the above-described polymer compound A, the above-described polymer compound B and the above-described polymer compound C further contain a constitutional unit represented by the formula (X): 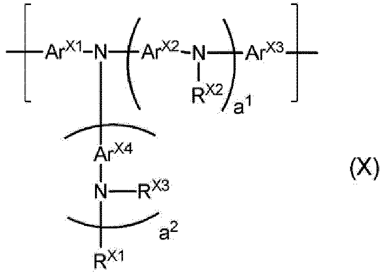 [wherein,
   a¹ and a² each independently represent an integer of 0 or more.
   Ar^{X1} and Ar^{X3} each independently represent an arylene group or a divalent heterocyclic group, and these groups optionally have a substituent.
   Ar^{X2} and Ar^{X4} each independently represent an arylene group, a divalent heterocyclic group, or a divalent group in which at least one arylene group and at least one divalent heterocyclic group are bonded directly, and these groups optionally have a substituent. When a plurality of Ar^{X2} and Ar^{X4} are present, they may be the same or different at each occurrence.
   R^{X1}, R^{X2} and R^{X3} each independently represent a hydrogen atom, an alkyl group, a cycloalkyl group, an aryl group or a monovalent heterocyclic group, and these groups optionally have a substituent. When a plurality of R^{X2} and R^{X3} are present, they may be the same or different at each occurrence.].
[4] The production method according to any one of [1] to [3], wherein
   the above-described constitutional unit (1-1) is a constitutional unit represented by the formula (2-1), and the above-described constitutional unit (1-2) is a constitutional unit represented by the formula (2-2): 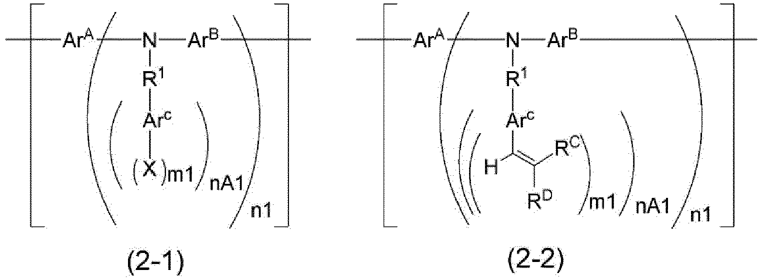 [wherein,
   n1 and nA1 each independently represent an integer of 1 to 3. When a plurality of nA1 are present, they may be the same or different.
   m1 represents an integer of 1 or more. When a plurality of m1 are present, they may be the same or different.
   X represents a formyl group, a hydrogen atom, an alkyl group, a cycloalkyl group, an aryl group or a monovalent heterocyclic group. When X is an alkyl group, a cycloalkyl group, an aryl group or a monovalent heterocyclic group, these groups optionally have a substituent. When a plurality of X are present, they may be the same or different. However, at least one X is a formyl group.
   Ar^{A} and Ar^{B} each independently represent an arylene group or a divalent heterocyclic group, and these groups optionally have a substituent. Ar^{C} represents an aromatic hydrocarbon ring or a heterocyclic group, and these groups optionally have a substituent. When a plurality of Ar^{B} and Ar^{C} are present, they may be the same or different at each occurrence. At least two or more of Ar^{A}, Ar^{B} and Ar^{C} may be combined together to form a ring.
   R¹ represents a single bond or an aliphatic hydrocarbon group, and these groups optionally have a substituent. When a plurality of R¹ are present, they may be the same or different. However, nA1 is 1 when R¹ is a single bond.
   R^{C} and R^{D} each independently represent a hydrogen atom, an alkyl group, a cycloalkyl group, an aryl group or a monovalent heterocyclic group, and these groups optionally have a substituent. When a plurality of R^{C} and R^{D} are present, they may be the same or different at each occurrence.].
[5] The production method according to any one of [1] to [3], wherein
   the above-described constitutional unit (1-1) is a constitutional unit represented by the formula (3-1), and the above-described constitutional unit (1-2) is a constitutional unit represented by the formula (3-2): 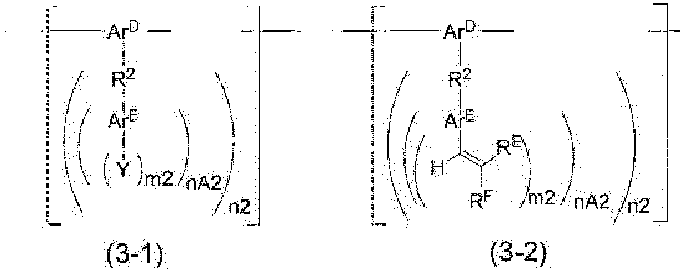 [wherein,
   n2 and nA2 each independently represent an integer of 1 to 3. When a plurality of nA2 are present, they may be the same or different.
   m2 represents an integer of 1 or more. When a plurality of m2 are present, they may be the same or different.
   Y represents a formyl group, a hydrogen atom, an alkyl group, a cycloalkyl group, an aryl group or a monovalent heterocyclic group. When Y is an alkyl group, a cycloalkyl group, an aryl group or a monovalent heterocyclic group, these groups optionally have a substituent. When a plurality of Y are present, they may be the same or different. However, at least one Y is a formyl group.
   Ar^{D} represents an aromatic hydrocarbon ring or a heterocyclic group, and these groups optionally have a substituent.
   Ar^{E} represents an aromatic hydrocarbon ring or a heterocyclic group, and these groups optionally have a substituent. When a plurality of Ar^{E} are present, they may be the same or different.
   R² represents a single bond or an aliphatic hydrocarbon group, and these groups optionally have a substituent. When a plurality of R² are present, they may be the same or different.
   R^{E} and R^{F} each independently represent a hydrogen atom, an alkyl group, a cycloalkyl group, an aryl group or a monovalent heterocyclic group, and these groups optionally have a substituent. When a plurality of R^{E} and R^{F} are present, they may be the same or different at each occurrence.].
[6] The production method according to any one of [1] to [3], wherein the above-described constitutional unit (1-1) is a constitutional unit represented by the formula (4-1), and the above-described constitutional unit (1-2) is a constitutional unit represented by the formula (4-2): 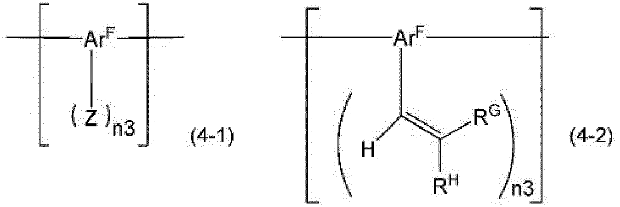 [wherein,
   n3 represents an integer of 1 to 3.
   Z represents a formyl group, a hydrogen atom, an alkyl group, a cycloalkyl group, an aryl group or a monovalent heterocyclic group. When Z is an alkyl group, a cycloalkyl group, an aryl group or a monovalent heterocyclic group, these groups optionally have a substituent. When a plurality of Z are present, they may be the same or different. However, at least one Z is a formyl group.
   Ar^{F} represents an aromatic hydrocarbon ring or a heterocyclic group, and these groups optionally have a substituent.
   R^{G} and R^{H} each independently represent a hydrogen atom, an alkyl group, a cycloalkyl group, an aryl group or a monovalent heterocyclic group, and these groups optionally have a substituent. When a plurality of R^{G} and R^{H} are present, they may be the same or different at each occurrence.].
[7] The production method according to any one of [1] to [6], comprising a step of purifying the resultant polymer compound A using an adsorbent, after the above-described second step.
[8] A light emitting device production method comprising a step of laminating an anode layer, organic layers and a cathode layer, wherein the method comprises a step of thermally hardening a raw material containing the polymer compound A obtained by using the production method as described in any one of [1] to [7] to form at least one of the above-described organic layers.

### Effect of the Invention

According to the present invention, a polymer compound production method which is capable of improving yield while lowering the dispersity of the molecular weight can be provided.

### Modes for Carrying Out the Invention

Suitable embodiments of the present invention will be described in detail below.

### <Explanation of common term>

The terms commonly used in the present specification have the following meanings, unless otherwise stated.

The hydrogen atom may be a heavy hydrogen atom or a light hydrogen atom.

"The polymer compound" means a polymer having molecular weight distribution and having a polystyrene-equivalent weight-average molecular weight of 1×10⁴ to 2×10⁸.

"The high molecular weight components" contained in the polymer compound B are a part of components contained in the polymer compound B, and mean a segment of the range in which the polystyrene-equivalent weight-average molecular weight is higher than that of the polymer compound B.

"The low molecular weight components" contained in the polymer compound B are a part of components contained in the polymer compound B, and mean a segment of the range in which the polystyrene-equivalent weight-average molecular weight is lower than that of the polymer compound B. Though the polystyrene-equivalent number-average molecular weight of the polymer compound B is not particularly restricted, it is preferably in the range of 1×10⁴ to 1×10⁸.

"The low-molecular compound" means a compound having no molecular weight distribution and having a molecular weight of 1×10⁴ or less.

"The constitutional unit" means a unit occurring once or more times (preferably five or more times) in a polymer compound.

"The aliphatic hydrocarbon" means an alkane or a cycloalkane. The hydrocarbon may be any of linear and branched. The number of carbon atoms of the linear alkane, not including the number of carbon atoms of the substituent, is usually 1 to 50, preferably 3 to 30, and more preferably 4 to 20. The number of carbon atoms of the branched alkane, not including the number of carbon atoms of the substituent, is usually 3 to 50, preferably 3 to 30, and more preferably 4 to 20.

The number of carbon atoms of the cycloalkane, not including the number of carbon atoms of the substituent, is usually 3 to 50, preferably 3 to 30, and more preferably 4 to 20. "The aliphatic hydrocarbon" means a group obtained by removing from the above-described hydrocarbon one or more hydrogen atoms.

"The alkyl group" may be any of linear and branched. The number of carbon atoms of the linear alkyl group, not including the number of carbon atoms of the substituent, is usually 1 to 50, preferably 3 to 30, and more preferably 4 to 20. The number of carbon atoms of the branched alkyl group, not including the number of carbon atoms of the substituent, is usually 3 to 50, preferably 3 to 30, and more preferably 4 to 20.

The alkyl group optionally has a substituent, and examples thereof include a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom or the like (for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group). When the alkyl group has a substituent, the number of the substituent is, for example, 1 to 2.

The number of carbon atoms of "the cycloalkyl group", not including the number of carbon atoms of the substituent, is usually 3 to 50, preferably 3 to 30, and more preferably 4 to 20.

The cycloalkyl group optionally has a substituent, and examples thereof include a cyclohexyl group, a cyclohexylmethyl group and a cyclohexylethyl group. When the cycloalkyl group has a substituent, the number of the substituent is, for example, 1 to 2.

"The aryl group" means an atomic group remaining after removing from an aromatic hydrocarbon one hydrogen atom bonding directly to a carbon atom constituting the ring. The number of carbon atoms of the aryl group, not including the number of carbon atoms of the substituent, is usually 6 to 60, preferably 6 to 20, and more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and groups obtained by substituting a hydrogen atom in these groups with an alkyl group, a cycloalkyl group, an alkoxy group, a cycloalkoxy group, an aryl group, a fluorine atom and the like, and preferable are groups represented by the formula (A-1) to the formula (A-37). When the aryl group has a substituent, the number of the substituent is, for example, 1 to 4. The aryl group includes groups obtained by bonding a plurality of these groups. 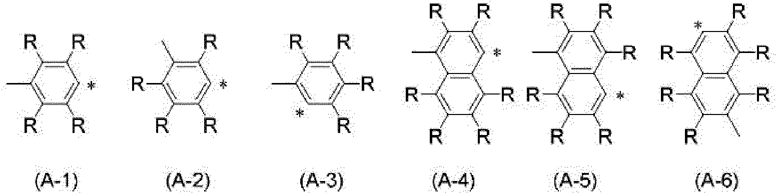 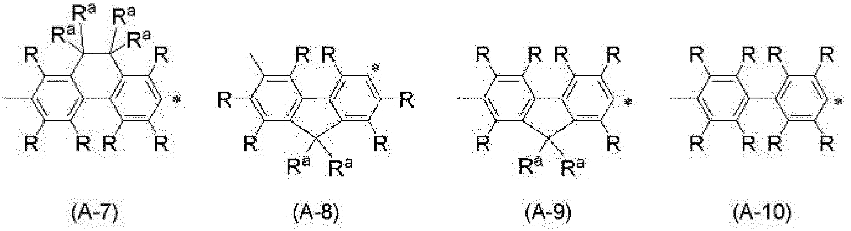 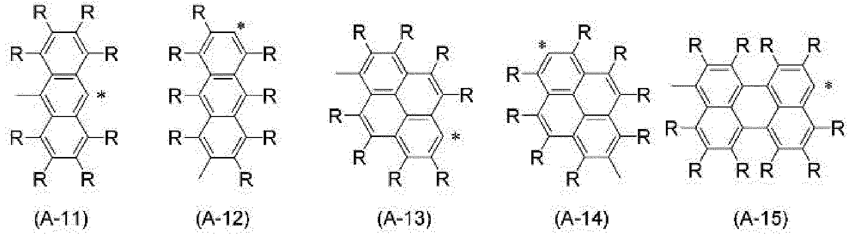 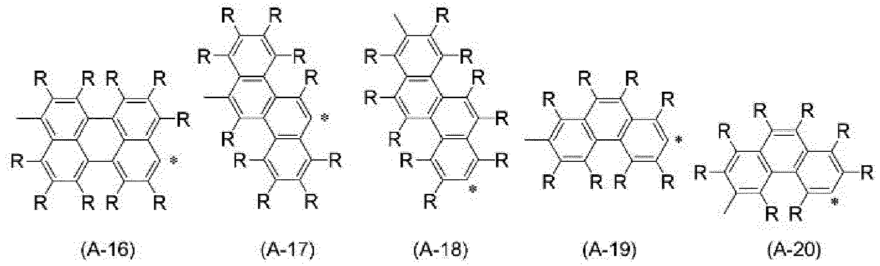 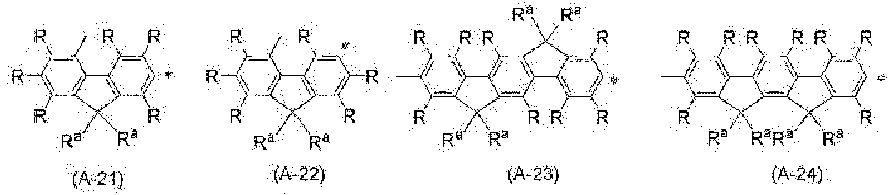 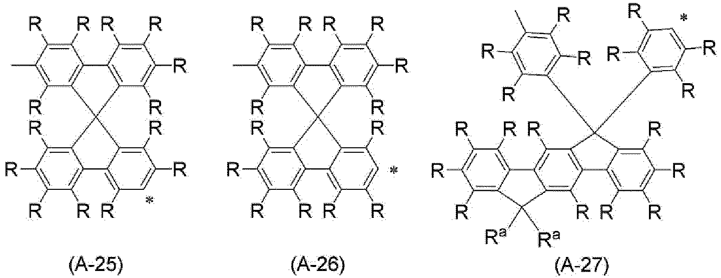 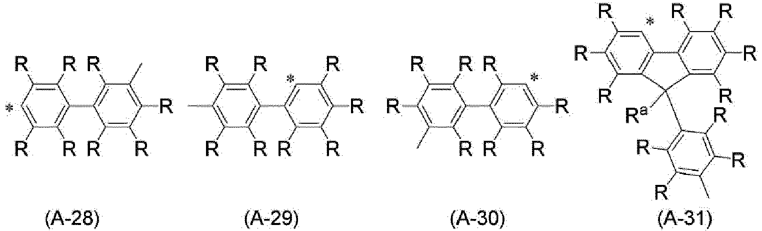 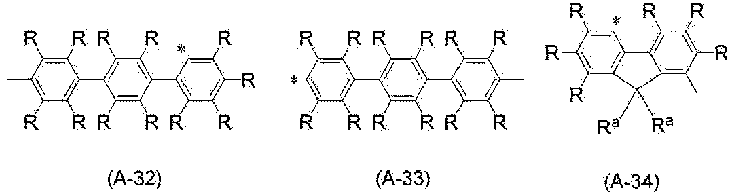 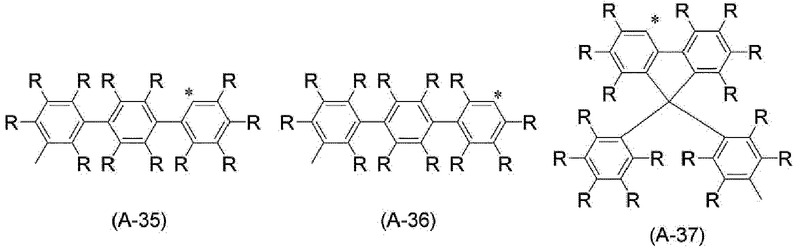 [wherein, R and R^{a} each independently represent a hydrogen atom, an alkyl group, a cycloalkyl group, an aryl group or a monovalent heterocyclic group. A plurality of R and R^{a} each may be the same or different, and the plurality of R^{a} may be combined together to form a ring together with atoms to which they are attached. A hydrogen atom at the position of * optionally has a substituent mentioned for R above.]

"The alkoxy group" may be any of linear and branched. The number of carbon atoms of the linear alkoxy group, not including the number of carbon atoms of the substituent, is usually 1 to 40, and preferably 4 to 10.

The number of carbon atoms of the branched alkoxy group, not including the number of carbon atoms of the substituent, is usually 3 to 40, and preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like. When the alkoxy group has a substituent, the number of the substituent is, for example, 1 to 2.

The number of carbon atoms of "the cycloalkoxy group", not including the number of carbon atoms of the substituent, is usually 3 to 40, and preferably 4 to 10.

The cycloalkoxy group optionally has a substituent, and examples thereof include a cyclohexyloxy group. When the cycloalkoxy group has a substituent, the number of the substituent is, for example, 1 to 2.

The number of carbon atoms of "the aryloxy group", not including the number of carbon atoms of the substituent, is usually 6 to 60, and preferably 6 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group and a 1-pyrenyloxy group, and groups obtained by substituting a hydrogen atom in these groups with an alkyl group, a cycloalkyl group, an alkoxy group, a cycloalkoxy group, a fluorine atom or the like. When the aryloxy group has a substituent, the number of the substituent is, for example, 1 to 3.

"The p-valent heterocyclic group" (p represents an integer of 1 or more) means an atomic group remaining after removing from a heterocyclic compound p hydrogen atoms among hydrogen atoms bonding directly to carbon atoms or hetero atoms constituting the ring. Of the p-valent heterocyclic groups, preferable is a "p-valent aromatic heterocyclic group" which is an atomic group remaining after removing from an aromatic heterocyclic compound p hydrogen atoms among hydrogen atoms bonding directly to carbon atoms or hetero atoms constituting the ring.

"The aromatic heterocyclic compound" means a compound in which the heterocycle itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like, and a compound in which an aromatic ring is condensed to a heterocycle even if the heterocycle itself shows no aromaticity such as phenoxazine, phenothiazine, dibenzoborole, dibenzosilole, benzopyran and the like.

The number of carbon atoms of the monovalent heterocyclic group, not including the number of carbon atoms of the substituent, is usually 2 to 60, and preferably 4 to 20.

The monovalent heterocyclic group optionally has a substituent, and examples thereof include a thienyl group, a pyrrolyl group, a furyl group, a pyridyl group, a piperidinyl group, a quinolinyl group, an isoquinolinyl group, a pyrimidinyl group and a triazinyl group, and groups obtained by substituting a hydrogen atom in these groups with an alkyl group, a cycloalkyl group, an alkoxy group, a cycloalkoxy group or the like. When the monovalent heterocyclic group has a substituent, the number of the substituent is, for example, 1 to 3. Groups represented by the formula (AA-1) to the formula (AA-36) are preferable. The monovalent heterocyclic group includes groups obtained by bonding a plurality of these groups. 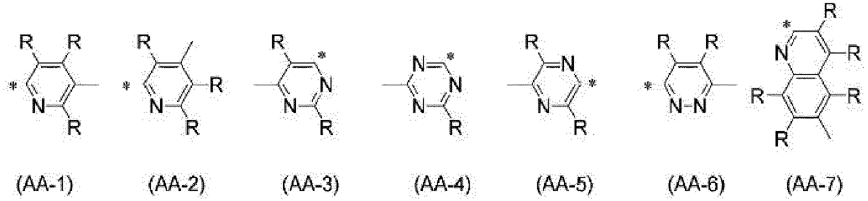 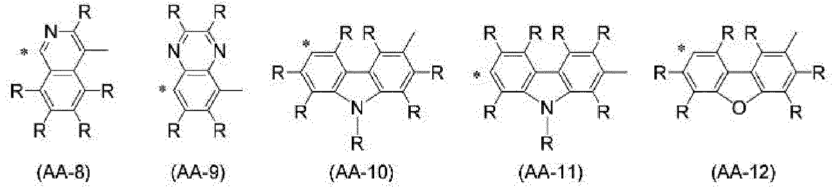 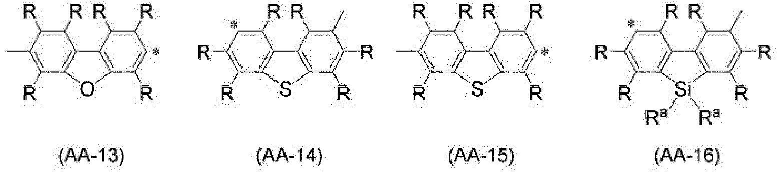 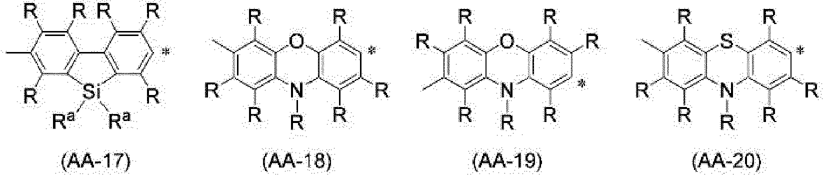 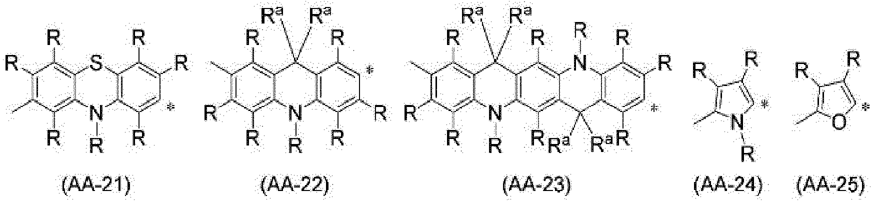 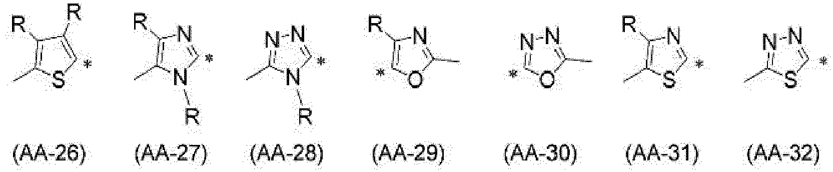 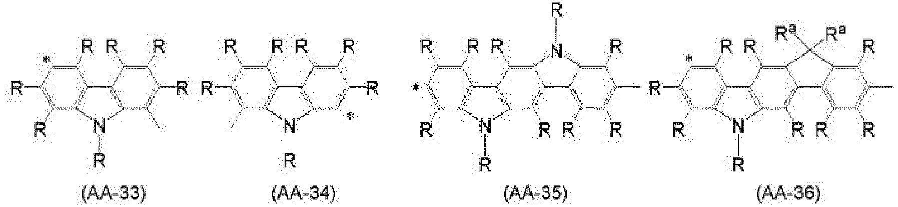 [wherein, R, R^{a} and * represent the same meaning as described above.]

"The halogen atom" means a fluorine atom, a chlorine atom, a bromine atom or an iodine atom.

"The amino group" optionally has a substituent, and substituted amino groups are preferred. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"The alkenyl group" may be any of linear and branched. The number of carbon atoms of the linear alkenyl group, not including the number of carbon atoms of the substituent, is usually 2 to 30, preferably 3 to 20.

The number of carbon atoms of the branched alkenyl group, not including the number of carbon atoms of the substituent, is usually 3 to 30, preferably 4 to 20.

The number of carbon atoms of "the cycloalkenyl group", not including the number of carbon atoms of the substituent, is usually 3 to 30, and preferably 4 to 20.

The alkenyl group and the cycloalkenyl group optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent. When the alkenyl group and the cycloalkenyl group have a substituent, the number of the substituent is, for example, 1 to 2.

"The alkynyl group" may be any of linear and branched. The number of carbon atoms of the alkynyl group, not including carbon atoms of the substituent, is usually 2 to 20, and preferably 3 to 20. The number of carbon atoms of the branched alkynyl group, not including carbon atoms of the substituent, is usually 4 to 30, and preferably 4 to 20.

The number of carbon atoms of "the cycloalkynyl group", not including carbon atoms of the substituent, is usually 4 to 30, and preferably 4 to 20.

The alkynyl group and the cycloalkynyl group optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent. When the alkynyl group and the cycloalkynyl group have a substituent, the number of the substituent is, for example, 1.

"The arylene group" means an atomic group remaining after removing from an aromatic hydrocarbon two hydrogen atoms bonding directly to carbon atoms constituting the ring. The number of carbon atoms of the arylene group, not including the number of carbon atoms of the substituent, is usually 6 to 60, and preferably 6 to 30.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, and these groups having a substituent, and preferable are groups represented by the formula (A-1') to the formula (A-37'). When arylene group has a substituent, the number of the substituent is, for example, 1 to 4. The arylene group includes groups obtained by bonding a plurality of these groups. 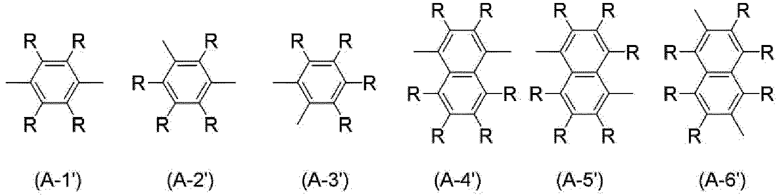 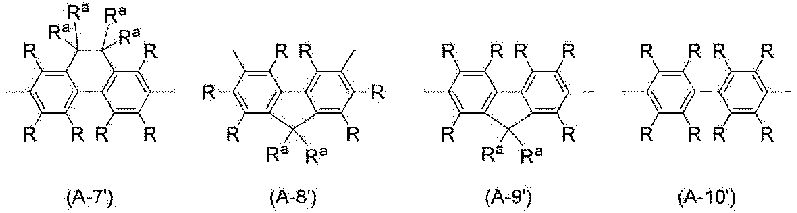 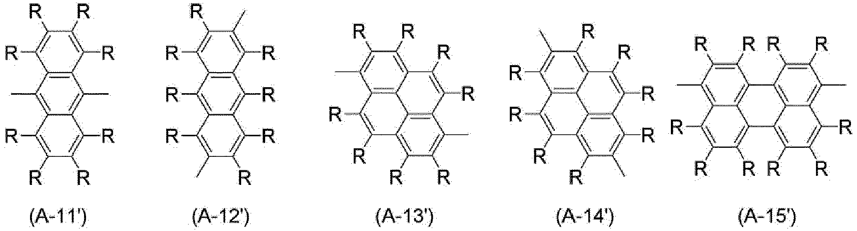 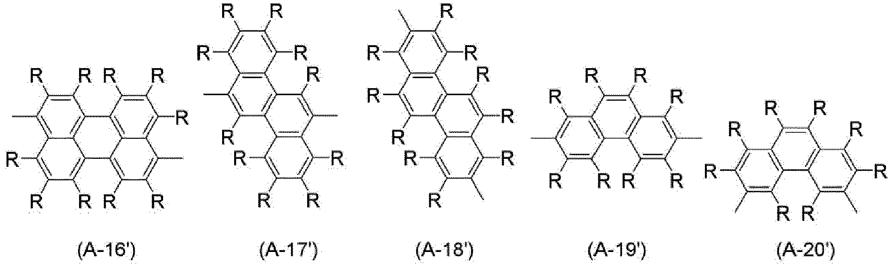 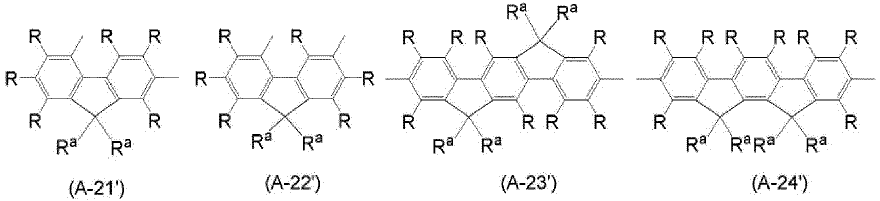 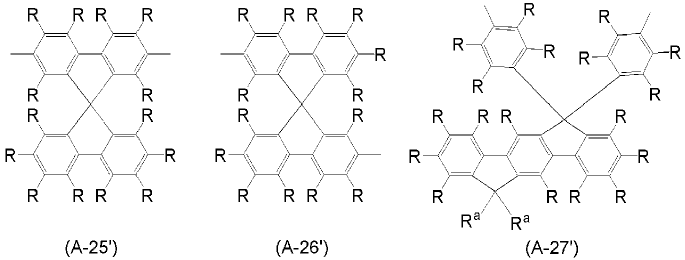 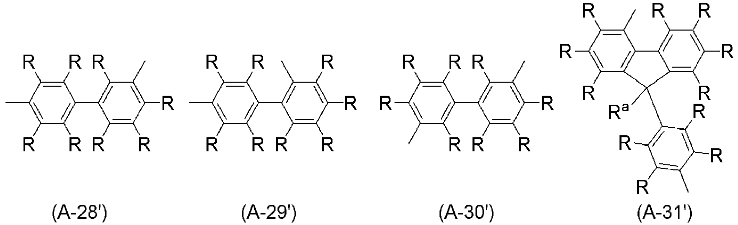 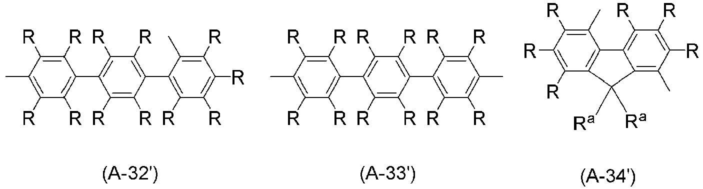 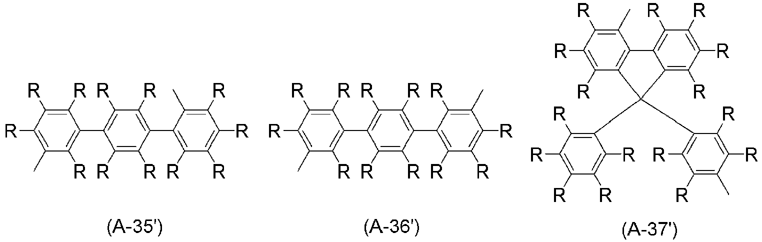 [wherein, R and R^{a} represent the same meaning as described above.]

The number of carbon atoms of the divalent heterocyclic group, not including the number of carbon atoms of the substituent, is usually 2 to 60, and preferably 3 to 20.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or triazole two hydrogen atoms among hydrogen atoms bonding directly to carbon atoms or hetero atoms constituting the ring, and preferable are groups represented by the formula (AA-1') to the formula (AA-36').

When the divalent heterocyclic group has a substituent, the number of the substituent is, for example, 1 to 3. The divalent heterocyclic group includes groups obtained by bonding a plurality of these groups. 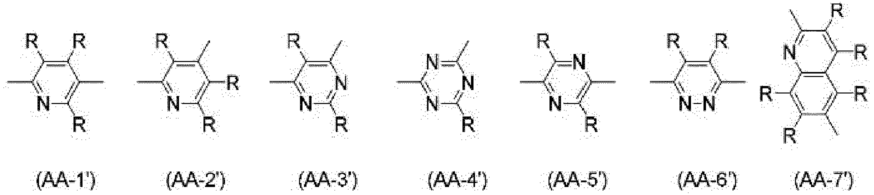 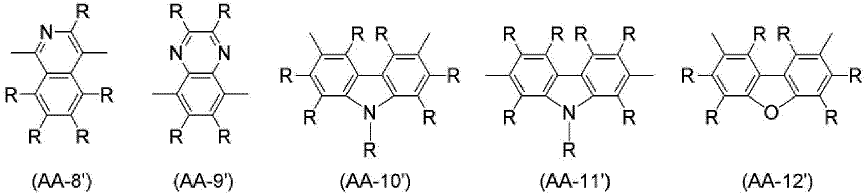 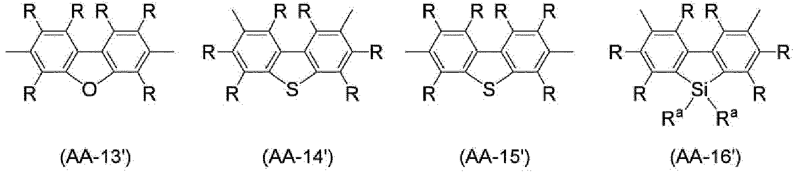 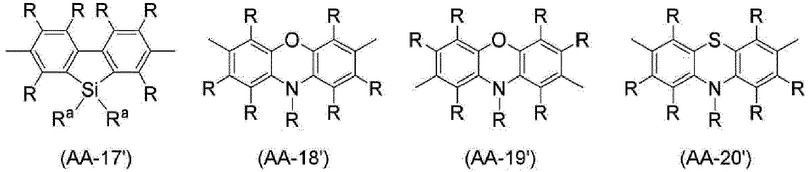 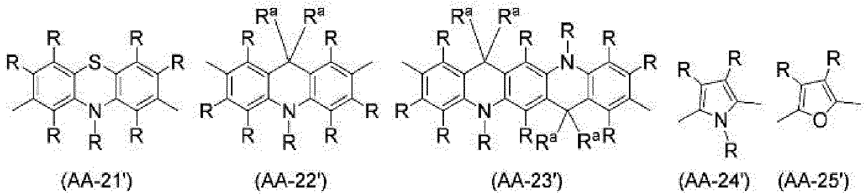 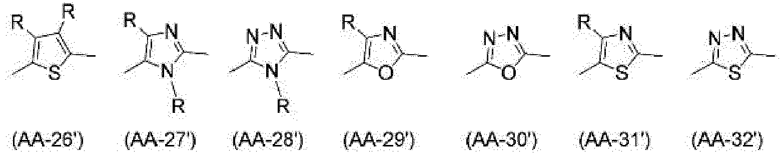 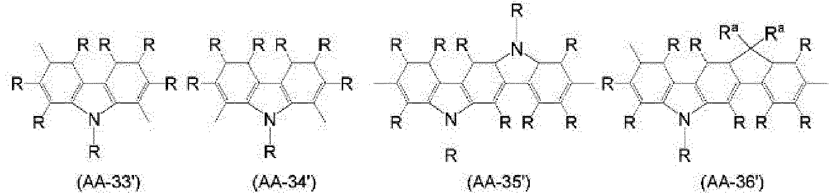 [wherein, R and R^{a} represent the same meaning as described above.]

"The crosslinkable group" is a group which is capable of generating a new bond by being substituted to heating, ultraviolet irradiation, near ultraviolet irradiation, visible light irradiation, infrared irradiation, radical reaction and the like. The crosslinkable group includes, for example, oxetane, cyclobenzobutene, epoxide and the like.

"The substituent" denotes, for example, a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group, unless explicitly stated otherwise. The substituent may be a crosslinkable group.

The meaning of "fractionation precipitation method" in the present specification will be explained. A method of dividing a sample into a plurality of segments having a narrow molecular weight range by utilizing the fact that the solubility of components having different molecular weights in a polymer compound having a molecular weight distribution varies depending on the molecular weight is called "fractionation". A solution prepared by mixing a poor solvent into the polymer solution is liquid-liquid separated into a phase rich in the high molecular weight components and a phase rich in low molecular weight components, by changing the kinds and the amount ratio of the good solvent and the poor solvent, or changing the temperature of the solution, by thermodynamic phase equilibrium. In this process, a method of recovering the phase rich in high molecular weight components is called "fractionation precipitation method". In this operation, low molecular weight components are removed, hence, the dispersity of the recovered high molecular weight components is smaller than the dispersity before conducting "the fractionation precipitation method".

### <Production method of polymer compound A>

The present invention provides a method of producing a polymer compound A containing the above-described constitutional unit (1-2), comprising a first step of separating high molecular weight components contained in a polymer compound B from the polymer compound B containing the above-described constitutional unit (1-1), by a fractionation precipitation method, to obtain a polymer compound C composed of the high molecular weight components, and a second step of converting the above-described constitutional unit (1-1) contained in the above-described polymer compound C obtained in the above-described first step into the above-described constitutional unit (1-2), to obtain the polymer compound A. In the present invention, the polymer compound A, the polymer compound B and the polymer compound C described above are generically referred to as "the polymer compound of the present invention" in some cases.

### <First step>

The content of the polymer compound C obtained by separating high molecular weight components from the polymer compound B in the first step is usually 20% by weight to 95% by weight, preferably 30% by weight to 90% by weight, and more preferably 40% by weight to 90% by weight, with respect to the total amount of the polymer compound B.

### [Constitutional unit (1-1)]

Ar¹ represents an aryl group optionally having a substituent or a monovalent heterocyclic group optionally having a substituent, and it is preferably an aryl group optionally having a substituent, more preferably a group represented by the formula (A-1) to the formula (A-37), and further preferably a group represented by the formula (A-1), the formula (A-2), the formula (A-6) to the formula (A-10), the formula (A-28) to the formula (A-31), and the formula (A-37), since the polymer compound A is synthesized more easily. In the formula [1-1], a formyl group is bonded to the aryl group or heterocyclic group portion represented by Ar¹.

When Ar¹ is a monovalent heterocyclic group, preferable are groups represented by the formula (AA-1) to the formula (AA-36).

In the present invention, the group obtained by removing from a compound represented by the formula [1-1] one or more hydrogen atoms present on Ar¹ is preferably a group obtained by removing one hydrogen atom (preferably, a hydrogen atom at the position of *) from a compound in which the Ar¹ portion in the formula [1-1] is an aryl group represented by the formula (A-1) to the formula (A-37) described above (more preferably, an aryl group represented by the formula (A-1), the formula (A-2), the formula (A-6) to the formula (A-10), the formula (A-28) to the formula (A-31), the formula (A-37)). Further, in another embodiment of the present invention, the group obtained by removing from a compound represented by the formula [1-1] one or more hydrogen atoms present on Ar¹ is preferably a group obtained by removing one hydrogen atom (preferably, a hydrogen atom at the position of *) from a compound in which the Ar¹ portion in the formula [1-1] is a monovalent heterocyclic group represented by the formula (AA-1) to the formula (AA-36).

The above-described constitutional unit (1-1) is preferably a constitutional unit represented by the above-described formula (2-1), a constitutional unit represented by the above-described formula (3-1) or a constitutional unit represented by the above-described formula (4-1), more preferably a constitutional unit represented by the above-described formula (2-1) or a constitutional unit represented by the above-described formula (3-1), and further preferably a constitutional unit represented by the above-described formula (2-1), since the polymer compound A is synthesized more easily.

The content of the constitutional unit (1-1) is preferably 0.5 to 50% by mol, more preferably 3 to 30% by mol, and further preferably 5 to 25% by mol, with respect to the total amount of constitutional units contained in the polymer compound B or the polymer compound C, since the polymer compound A is excellent in crosslinkability.

The constitutional unit (1-1) may be contained only singly or in combination of two or more in the polymer compound B or the polymer compound C.

### [Constitutional unit represented by the formula (2-1)]

n1 is preferably 1 or 2, and more preferably 1.

nA1 is preferably 1 or 2, and more preferably 1.

m1 is preferably an integer of 1 to 5, more preferably an integer of 1 to 3, and further preferably 1.

and Ar^{B} are each preferably an arylene group optionally having a substituent, and more preferably a group represented by the formula (A-1'), the formula (A-2'), the formula (A-6') to the formula (A-10'), the formula (A-28') to the formula (A-31'), and the formula (A-37'). At least two or more of Ar^{A}, Ar^{B} and Ar^{C} may be combined together to form a ring.

When or Ar^{B} is a divalent heterocyclic group, preferable are groups represented by the formula (AA-1') to the formula (AA-36').

The number of carbon atoms of the aromatic hydrocarbon group represented by Ar^{C}, not including the number of carbon atoms of the substituent, is usually 6 to 60, preferably 6 to 30.

The arylene group portion obtained by removing (m1-1) substituents of the aromatic hydrocarbon group represented by Ar^{C} is preferably a group represented by the formula (A-1') to the formula (A-37'), and more preferably a group represented by the formula (A-1'), the formula (A-2'), the formula (A-6') to the formula (A-10'), the formula (A-28') to the formula (A-31'), and the formula (A-37'). These groups optionally have a substituent.

The number of carbon atoms of the heterocyclic group represented by Ar^{C}, not including the number of carbon atoms of the substituent, is usually 2 to 60, preferably 3 to 30.

The divalent heterocyclic group portion obtained by removing (m1-1) substituents of the heterocyclic group represented by Ar^{C} is preferably a group represented by the formula (AA-1') to the formula (AA-36').

R¹ is preferably a single bond.

When R¹ is a (nA1+1)-valent aliphatic hydrocarbon group, the number of carbon atoms of the aliphatic hydrocarbon group, not including the number of carbon atoms of the substituent, is usually 6 to 60, preferably 6 to 30, and more preferably 6 to 18. The alkane portion or the cycloalkane portion obtained by removing (nA1+1) substituents (-Ar^{c}-(X)ₘ₁ and 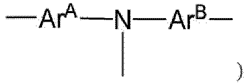 of the aliphatic hydrocarbon group represented by R¹ optionally has another substituent, and examples thereof include methane, ethane, propane, butane, pentane, hexane, heptane, octane, decane, dodecane, cyclopentane and cyclohexane groups. When the alkane portion or the cycloalkane portion obtained by removing (nA1+1) substituents (-Ar^{c}-(X)ₘ₁ and 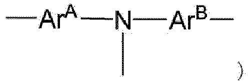 of the aliphatic hydrocarbon group represented by R¹ has a substituent, the number of the substituent is, for example, 1 to 4.

The content of the constitutional unit represented by the formula (2-1) is preferably 0.5 to 50% by mol, more preferably 3 to 30% by mol, and further preferably 5 to 25% by mol, with respect to the total amount of constitutional units contained in the polymer compound B or the polymer compound C, since the polymer compound A is excellent in crosslinkability.

The constitutional unit represented by the formula (2-1) may be contained only singly or in combination of two or more in the polymer compound B or the polymer compound C.

The above-described constitutional unit represented by the formula (2-1) is preferably a constitutional unit represented by the formula (2-1-1) to the formula (2-1-12). The constitutional unit represented by the formula (2-1-1) to the formula (2-1-12) optionally has a substituent. 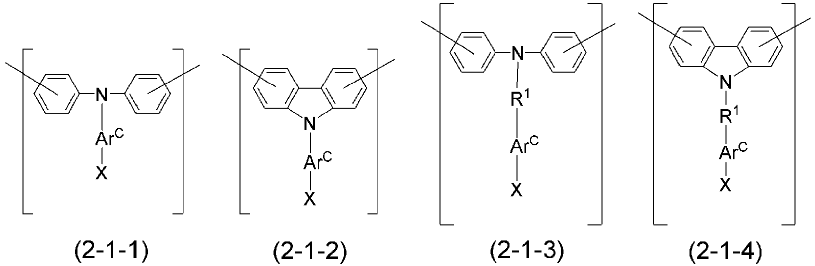 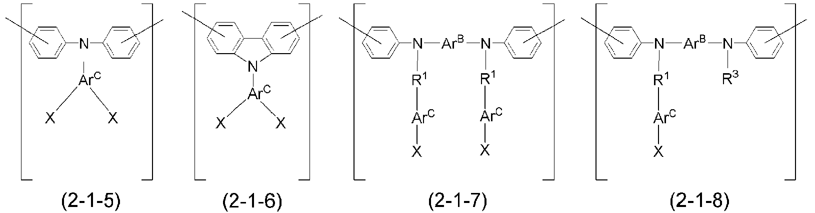 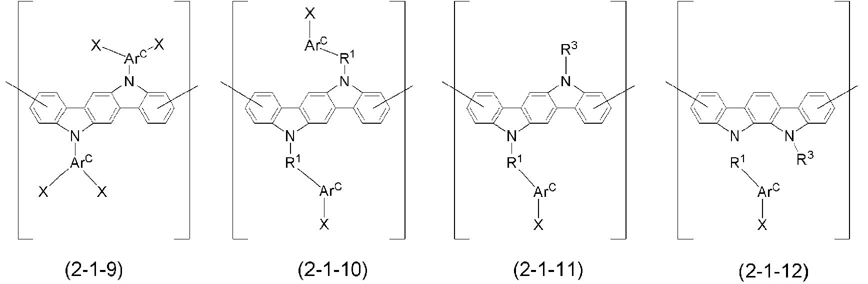 [wherein, X, Ar^{B}, Ar^{C} and R¹ represent the same meaning as described above. R³ represents a hydrogen atom, an alkyl group, a cycloalkyl group, an aryl group or a monovalent heterocyclic group, and these groups optionally have a substituent. When a plurality of R³ are present, they may be the same or different.]

### [Constitutional unit represented by the formula (3-1)]

n2 is preferably 1 or 2, and more preferably 1.

nA2 is preferably 1 or 2, and more preferably 1.

m2 is preferably an integer of 1 to 5, more preferably an integer of 1 to 3, and further preferably 1.

The number of carbon atoms of the aromatic hydrocarbon group represented by Ar^{E}, not including the number of carbon atoms of the substituent, is usually 6 to 60, and preferably 6 to 30.

The arylene group portion obtained by removing (m2-1) substituents of the aromatic hydrocarbon group represented by Ar^{E} is preferably a group represented by the formula (A-1') to the formula (A-37'), and more preferably a group represented by the formula (A-1'), the formula (A-2'), the formula (A-6') to the formula (A-10'), the formula (A-28') to the formula (A-31'), and the formula (A-37'). These groups optionally have a substituent.

The number of carbon atoms of the heterocyclic group represented by Ar^{E}, not including the number of carbon atoms of the substituent, is usually 2 to 60, and preferably 3 to 30.

The divalent heterocyclic group portion obtained by removing (m2-1) substituents of the heterocyclic group represented by Ar^{E} is preferably a group represented by the formula (AA-1') to the formula (AA-36').

R² is preferably a single bond or a (nA2+1)-valent aromatic hydrocarbon group. These groups optionally have a substituent.

When R² is a (nA2+1)-valent aliphatic hydrocarbon group, the number of carbon atoms of the aliphatic hydrocarbon group, not including the number of carbon atoms of the substituent, is usually 6 to 60, preferably 6 to 30, and more preferably 6 to 18. The alkane portion or the cycloalkane portion obtained by removing (nA2+1) substituents of the aliphatic hydrocarbon group represented by R² optionally has a substituent, and examples thereof include methane, ethane, propane, butane, pentane, hexane, heptane, octane, decane, dodecane, cyclopentane and cyclohexane groups. When the alkane portion or the cycloalkane portion obtained by removing (nA2+1) substituents of the hydrocarbon group represented by R² has a substituent, the number of the substituent is, for example, 1 to 4.

The number of carbon atoms of the aromatic hydrocarbon group represented by Ar^{D}, not including the number of carbon atoms of the substituent, is usually 6 to 60, and preferably 6 to 30.

The arylene group portion obtained by removing (n2) substituents of the aromatic hydrocarbon group presented by Ar^{D} is preferably a group represented by the formula (A-1') to the formula (A-37'), and more preferably a group represented by the formula (A-1'), the formula (A-2'), the formula (A-6') to the formula (A-10'), the formula (A-28') to the formula (A-31'), and the formula (A-37'). These groups optionally have a substituent.

The number of carbon atoms of the heterocyclic group represented by Ar^{D}, not including the number of carbon atoms of the substituent, is usually 2 to 60, and preferably 3 to 30.

The divalent heterocyclic group portion obtained by removing (n2) substituents of the heterocyclic group represented by Ar^{D} is preferably a group represented by the formula (AA-1') to the formula (AA-36').

The content of the constitutional unit represented by the formula (3-1) is preferably 0.5 to 50% by mol, more preferably 3 to 30% by mol, and further preferably 5 to 25% by mol, with respect to the total amount of constitutional units contained in the polymer compound B or the polymer compound C, since the polymer compound A is excellent in crosslinkability.

The constitutional unit represented by the formula (3-1) may be contained only singly or in combination of two or more in the polymer compound B or the polymer compound C.

The above-described constitutional unit represented by the formula (3-1) is preferably a constitutional unit represented by the formula (3-1-1) to the formula (3-1-16). The constitutional unit represented by the formula (3-1-1) to the formula (3-1-16) optionally has a substituent. 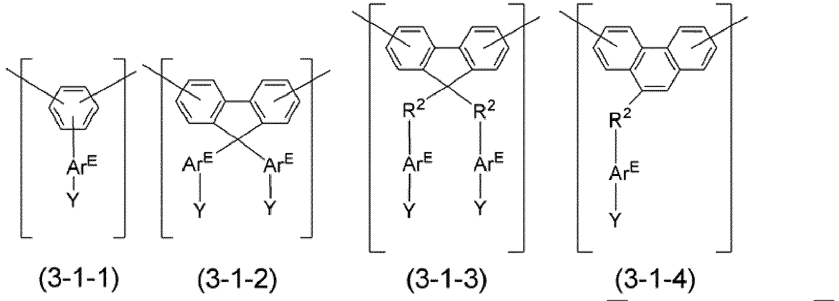 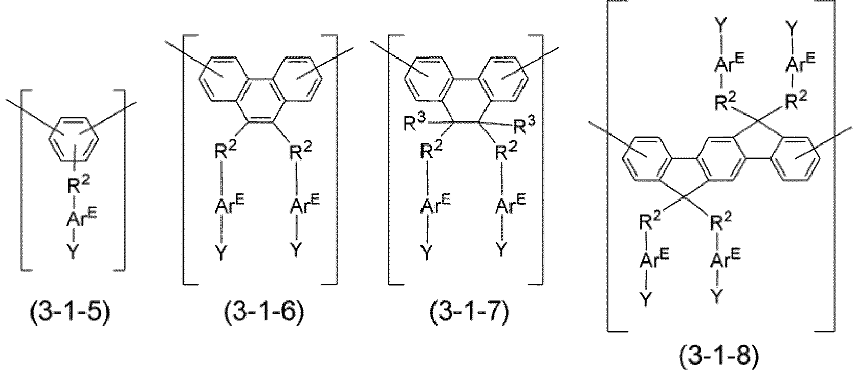 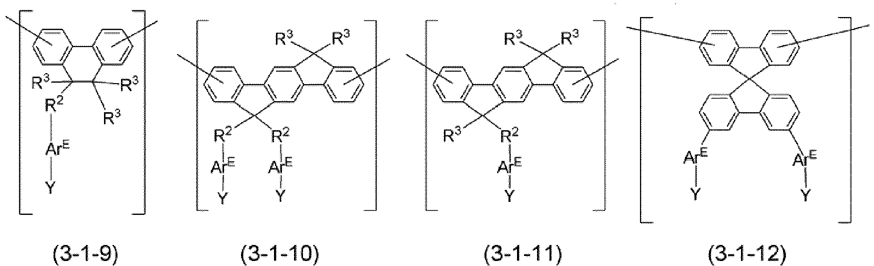 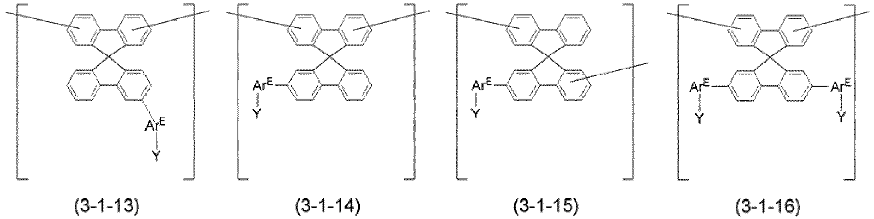 [wherein, Y, Ar^{E} and R² represent the same meaning as described above. R³ represents a hydrogen atom, an alkyl group, a cycloalkyl group, an aryl group or a monovalent heterocyclic group, and these groups optionally have a substituent. When a plurality of R³ are present, they may be the same or different.]

### [Constitutional unit represented by the formula (4-1)]

n3 is preferably 1 or 2, and more preferably 1.

The number of carbon atoms of the aromatic hydrocarbon group represented by Ar^{F}, not including the number of carbon atoms of the substituent, is usually 6 to 60, and preferably 6 to 30.

The arylene group portion obtained by removing (n3) substituents of the aromatic hydrocarbon group represented by Ar^{F} is preferably a group represented by the formula (A-1') to the formula (A-37'), and more preferably a group represented by the formula (A-1'), the formula (A-2'), the formula (A-6') to the formula (A-10'), the formula (A-28') to the formula (A-31'), and the formula (A-37'). These groups optionally have a substituent.

The number of carbon atoms of the heterocyclic group represented by Ar^{F}, not including the number of carbon atoms of the substituent, is usually 2 to 60, and preferably 3 to 30.

The divalent heterocyclic group portion obtained by removing (n3) substituents of the heterocyclic group represented by Ar^{F} is preferably a group represented by the formula (AA-1') to the formula (AA-36').

The content of the constitutional unit represented by the formula (4-1) is preferably 0.5 to 50% by mol, more preferably 3 to 30% by mol, and further preferably 5 to 25% by mol, with respect to the total amount of constitutional units contained in the polymer compound B or the polymer compound C, since the polymer compound A is excellent in crosslinkability.

The constitutional unit represented by the formula (4-1) may be contained only singly or in combination of two or more in the polymer compound B or the polymer compound C.

The above-described constitutional unit represented by the formula (4-1) is preferably a constitutional unit represented by the formula (4-1-1). The constitutional unit represented by the formula (4-1-1) optionally has a substituent. 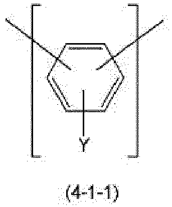 [wherein, Y represents the same meaning as described above.]

### [Constitutional unit (1-2)]

Ar¹ represents the same meaning as described above. In the formula [1-2], the group 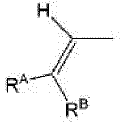 is bonded to an aryl group or heterocyclic group portion in Ar¹.

In the present invention, the group obtained by removing from a compound represented by the formula [1-2] one or more hydrogen atoms present on Ar¹ is preferably a group obtained by removing one hydrogen atom (preferably, a hydrogen atom at the position of *) from a compound in which the Ar¹ portion in the formula [1-2] is an aryl group represented by the formula (A-1) to the formula (A-37) described above (more preferably, an aryl group represented by the formula (A-1), the formula (A-2), the formula (A-6) to the formula (A-10), the formula (A-28) to the formula (A-31), the formula (A-37)). Further, in another embodiment of the present invention, the group obtained by removing from a compound represented by the formula [1-2] one or more hydrogen atoms present on Ar¹ is preferably a group obtained by removing one hydrogen atom (preferably, a hydrogen atom at the position of *) from a compound in which the Ar¹ portion is a monovalent heterocyclic group represented by the formula (AA-1) to the formula (AA-36) in the formula [1-2].

R^{A} and R^{B} are each preferably a hydrogen atom, an alkyl group or an aryl group, and more preferably a hydrogen atom. It is preferable that at least one of R^{A} and R^{B} is a hydrogen atom.

The above-described constitutional unit (1-2) is preferably a constitutional unit represented by the above-described formula (2-2), a constitutional unit represented by the above-described formula (3-2) or a constitutional unit represented by the above-described formula (4-2), more preferably a constitutional unit represented by the above-described formula (2-2) or a constitutional unit represented by the above-described formula (3-2), and further preferably a constitutional unit represented by the above-described formula (2-2), since the polymer compound A is synthesized more easily.

The content of the constitutional unit (1-2) is preferably 0.5 to 50% by mol, more preferably 3 to 30% by mol, and further preferably 5 to 25% by mol, with respect to the total amount of constitutional units contained in the polymer compound A, since the polymer compound A is excellent in crosslinkability.

The constitutional unit (1-2) may be contained only singly or in combination of two or more in the polymer compound A.

### [Constitutional unit represented by the formula (2-2)]

n1, nA1, X, Ar^{A}, Ar^{B}, Ar^{C} and R¹ represent the same meaning as described above.

R^{C} and R^{D} are each preferably a hydrogen atom, an alkyl group or an aryl group, and more preferably a hydrogen atom. It is preferable that at least one of R^{A} and R^{B} is a hydrogen atom.

The content of the constitutional unit represented by the formula (2-2) is preferably 0.5 to 50% by mol, more preferably 3 to 30% by mol, and further preferably 5 to 25% by mol, with respect to the total amount of constitutional units contained in the polymer compound A, since the polymer compound A is excellent in crosslinkability.

The constitutional unit represented by the formula (2-2) may be contained only singly or in combination of two or more in the polymer compound A.

The above-described constitutional unit represented by the formula (2-2) is preferably a constitutional unit represented by the formula (2-2-1) to the formula (2-2-12). The constitutional unit represented by the formula (2-2-1) to the formula (2-2-12) optionally has a substituent. 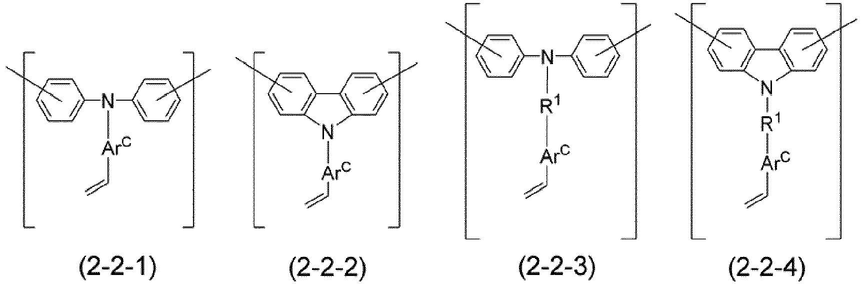 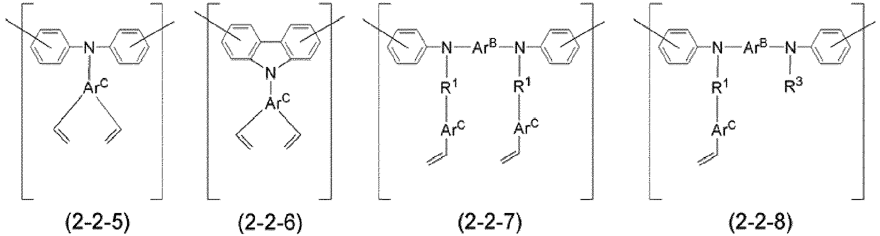 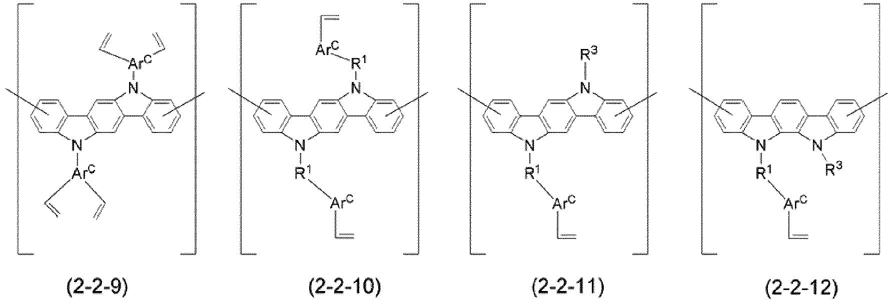 [wherein, Ar^{B}, Ar^{C}, R¹ and R³ represent the same meaning as described above.]

### [Constitutional unit represented by the formula (3-2)]

n2, nA2, Y, Ar^{E}, R² or Ar^{D} represent the same meaning as described above.

R^{E} and R^{F} are each preferably a hydrogen atom, an alkyl group or an aryl group, and more preferably a hydrogen atom. It is preferable that at least one of R^{E} and R^{F} is a hydrogen atom.

The content of the constitutional unit represented by the formula (3-2) is preferably 0.5 to 50% by mol, more preferably 3 to 30% by mol, and further preferably 5 to 25% by mol, with respect to the total amount of constitutional units contained in the polymer compound A, since the polymer compound A is excellent in crosslinkability.

The constitutional unit represented by the formula (3-2) may be contained only singly or in combination of two or more in the polymer compound A.

The above-described constitutional unit represented by the formula (3-2) is preferably a constitutional unit represented by the formula (3-2-1) to the formula (3-2-16). The constitutional unit represented by the formula (3-2-1) to the formula (3-2-16) optionally has a substituent. 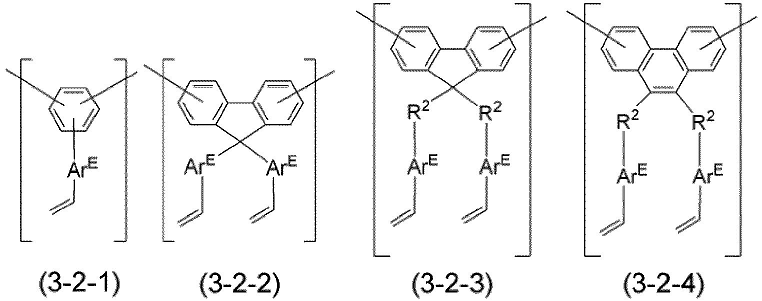 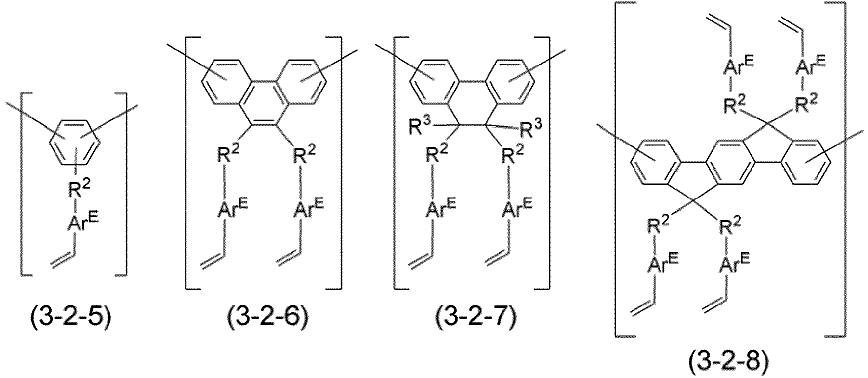 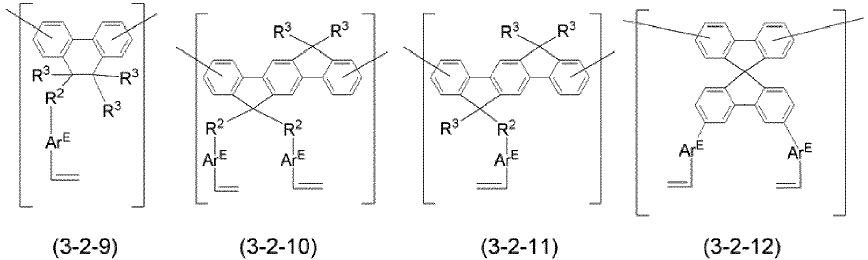 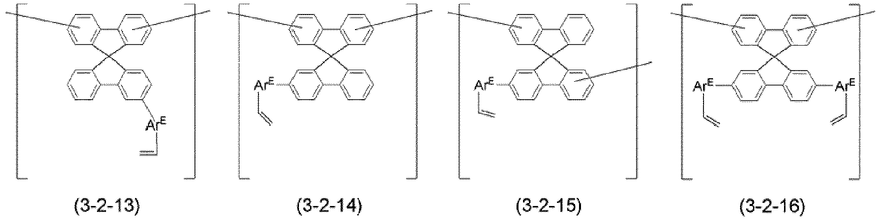 [wherein, Ar^{E}, R² and R³ represent the same meaning as described above.]

### [Constitutional unit represented by the formula (4-2)]

n3, Z or Ar^{F} represent the same meaning as described above.

R^{G} and R^{H} are each preferably a hydrogen atom, an alkyl group or an aryl group, and more preferably a hydrogen atom. It is preferable that at least one of R^{G} and R^{H} is a hydrogen atom.

The content of the constitutional unit represented by the formula (4-2) is preferably 0.5 to 50% by mol, more preferably 3 to 30% by mol, and further preferably 5 to 25% by mol, with respect to the total amount of constitutional units contained in the polymer compound A, since the polymer compound A is excellent in crosslinkability.

The constitutional unit represented by the formula (4-2) may be contained only singly or in combination of two or more in the polymer compound A.

The above-described constitutional unit represented by the formula (4-2) is preferably a constitutional unit represented by the formula (4-2-1). The constitutional unit represented by the formula (4-2-1) optionally has a substituent.

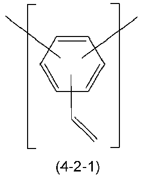

The constitutional unit (1-1) having a group obtained by removing from a compound represented by the formula [1-1] one or more hydrogen atoms present on Ar¹ includes the following constitutional units and the like, in addition to the above-described constitutional units represented by the formula (2-1), the formula (3-1) and the formula (4-1).

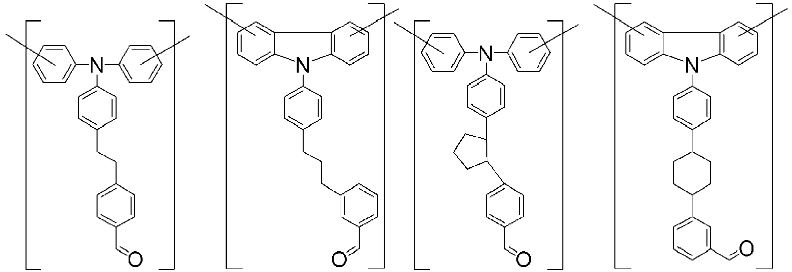

The constitutional unit (1-2) having a group obtained by removing from a compound represented by the formula [1-2] one or more hydrogen atoms present on Ar¹ includes the following constitutional units and the like, in addition to the above-described constitutional units represented by the formula (2-2), the formula (3-2) and the formula (4-2).

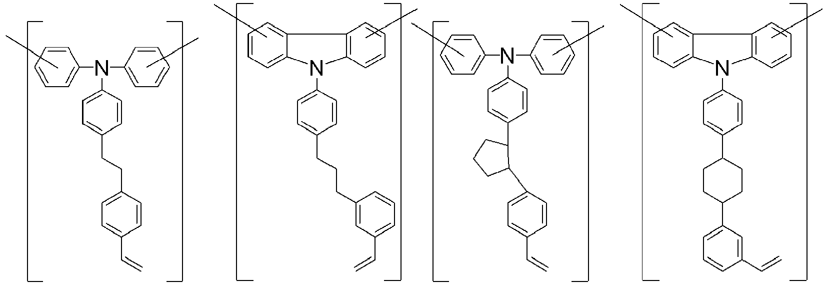

### [Constitutional unit represented by the formula (X)]

The polymer compound of the present invention may further contain a constitutional unit represented by the above-described formula (X). The constitutional unit represented by the formula (X) is different from the above-described constitutional unit represented by the formula (2-1) or (2-2).

a¹ is preferably an integer of 2 or less, and more preferably 0 or 1, since a light emitting device using the polymer compound A is excellent in luminance life.

a² is preferably an integer of 2 or less, and more preferably 0, since a light emitting device using the polymer compound A is excellent in luminance life.

R^{X1}, R^{X2} and R^{X3} are each preferably an alkyl group, a cycloalkyl group, an aryl group or a monovalent heterocyclic group, and more preferably an aryl group, and these groups optionally have a substituent.

The arylene group represented by Ar^{X1} and Ar^{X3} is more preferably a group represented by the formula (A-1') or the formula (A-9'), and further preferably a group represented by the formula (A-1'), and these groups optionally have a substituent.

The divalent heterocyclic group represented by Ar^{X1} and Ar^{X3} is more preferably a group represented by the formula (AA-1'), the formula (AA-2') or the formula (AA-7') to the formula (AA-26'), and these groups optionally have a substituent.

When the arylene group or the divalent heterocyclic group represented by Ar^{X1} and Ar^{X3} has a substituent, the substituent is not a formyl group. When Ar^{X2} and/or Ar^{X3} is an arylene group having a substituent or a divalent heterocyclic group having a substituent, the substituent is not a formyl group. When R^{X1}, R^{X2} and R^{X3} are each an aryl group or a monovalent heterocyclic group having a substituent, the substituent is not a formyl group.

Ar^{X1} and Ar^{X3} are each preferably an arylene group optionally having a substituent.

The arylene group represented by Ar^{X2} and Ar^{X4} is more preferably a group represented by the formula (A-1'), the formula (A-6'), the formula (A-7'), the formula (A-9') to the formula (A-11') or the formula (A-19'), and these groups optionally have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and the further preferable range of the arylene group and the divalent heterocyclic group in the divalent group in which at least one arylene group and at least one divalent heterocyclic group are bonded directly represented by Ar^{X2} and Ar^{X4} are the same as the more preferable range and the further preferable range of the arylene group and the divalent heterocyclic group represented by Ar^{X1} and Ar^{X3}, respectively.

The divalent group in which at least one arylene group and at least one divalent heterocyclic group are bonded directly represented by Ar^{X2} and Ar^{X4} includes, for example, groups represented by the following formulae, and these optionally have a substituent. 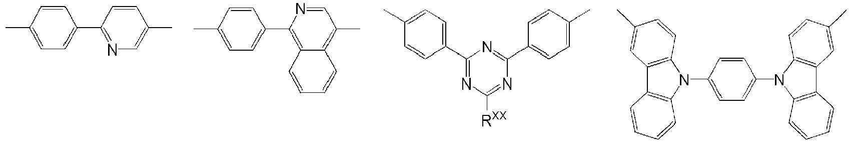 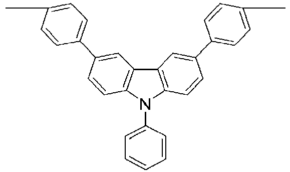 [wherein, R^{XX} represents a hydrogen atom, an alkyl group, a cycloalkyl group, an aryl group or a monovalent heterocyclic group, and these groups optionally have a substituent.]

R^{XX} is preferably an alkyl group, a cycloalkyl group or an aryl group, and these groups optionally have a substituent.

Ar^{X2} and Ar^{X4} are each preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups optionally further have a substituent.

As the constitutional unit represented by the formula (X), constitutional units represented by the formulae (X-1) to (X-17) are preferable. 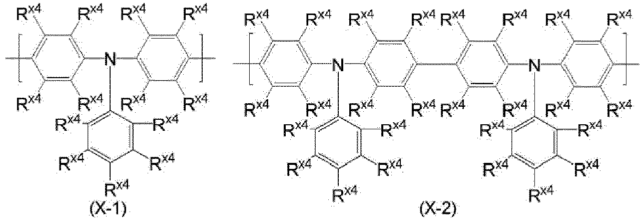 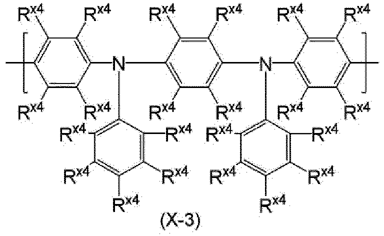 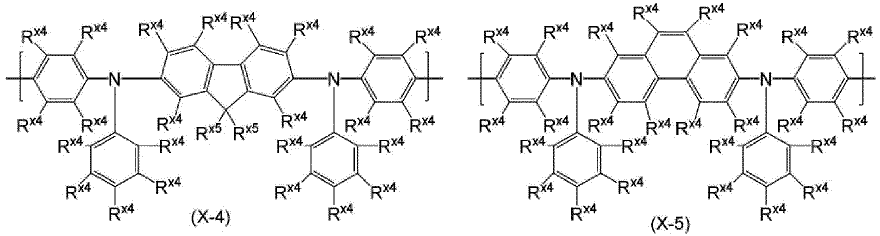 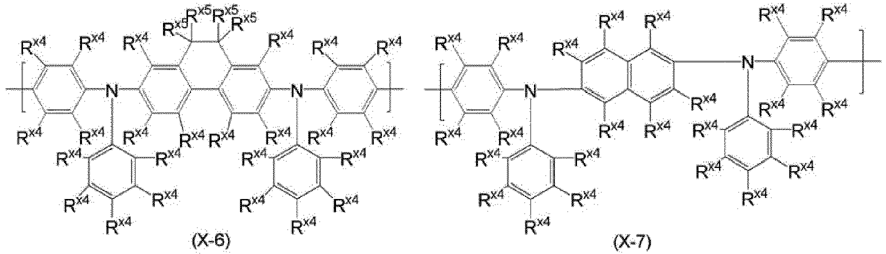 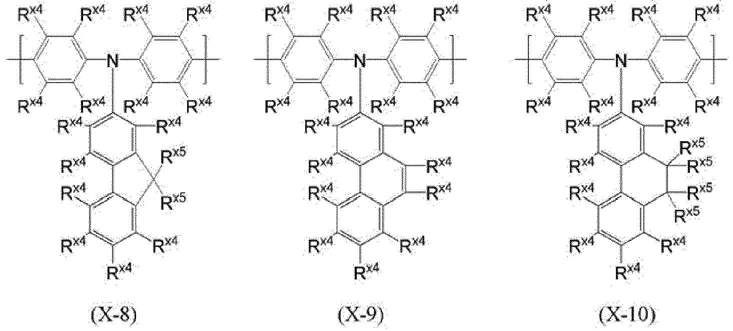 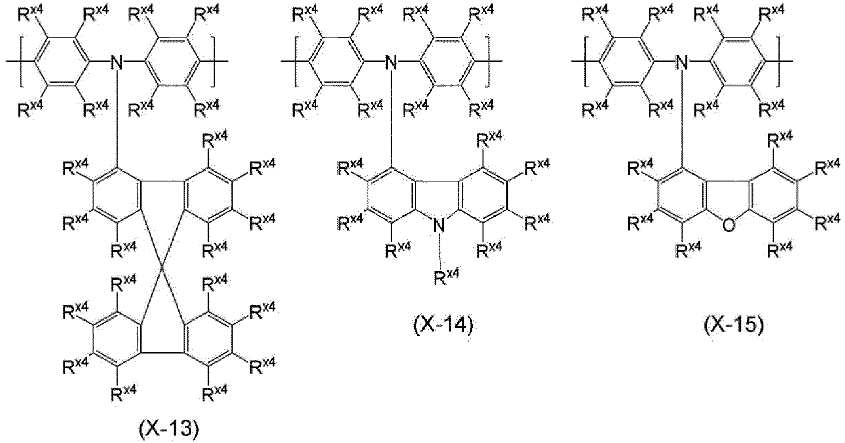 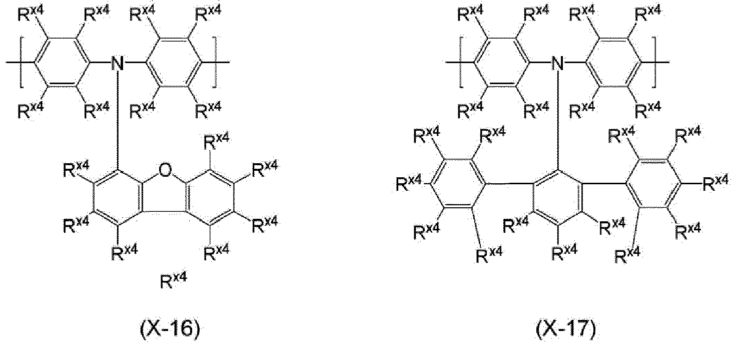 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups optionally have a substituent. A plurality of R^{X4} may be the same or different. A plurality of R^{X5} may be the same or different, and adjacent R^{X5} may be combined together to form a ring together with carbon atoms to which they are attached.]

The content of the constitutional unit represented by the formula (X) is preferably 0.1 to 50% by mol, more preferably 1 to 50% by mol, and further preferably 5 to 50% by mol, with respect to the total amount of constitutional units contained in the polymer compound A, the polymer compound B or the polymer compound C, since hole transportability is more excellent.

In the polymer compound of the present invention, the constitutional unit represented by the formula (X) may be contained only singly or in combination of two or more.

The polymer compound A includes, for example, polymer compounds P-3, P-4 and P-6. The polymer compound B or the polymer compound C includes, for example, polymer compounds P-1, P-2 and P-5. "Other" means a constitutional unit other than the constitutional units represented by the formula (2-1), the formula (2-2), the formula (3-1), the formula (3-2), the formula (4-1), the formula (4-2) and the formula (X) described above.

**[Table 1]**

| Polymer compound | Constitutional unit and molar ratio thereof | | | | | |
|---|---|---|---|---|---|---|
| | Formula (2-1) | Formula (2-2) | Formula (3-1) and/or formula (4-1) | Formula (3-2) and/or formula (4-2) | Formula (X) | Other |
| | q | r | s | t | u | v |
| P-1 | 0.1 to 99.9 | 0 | 0 | 0 | 0.1 to 99.9 | 0 to 90 |
| P-2 | 0 | 0 | 0.1 to 99.9 | 0 | 0.1 to 99.9 | 0 to 90 |
| P-3 | 0 | 0.1 to 99.9 | 0 | 0 | 0.1 to 99.9 | 0 to 90 |
| P-4 | 0 | 0 | 0 | 0.1 to 99.9 | 0.1 to 99.9 | 0 to 90 |
| P-5 | 0.1 to 99.8 | 0 | 0.1 to 99.8 | 0 | 0.1 to 99.8 | 0 to 90 |
| P-6 | 0 | 0.1 to 99.8 | 0 | 0.1 to 99.8 | 0.1 to 99.8 | 0 to 90 |

[in the table, q, r, s, t, u and v represent the molar ratio of each constitutional unit. q+r+s+t+u+v=100 and 10 ≤ q+r+s+t+u ≤ 100.]

It is preferable that the end group of the polymer compound of the present invention is a stable group since, if the polymerization active group remains intact at the end, the light emission property and the luminance life possibly lower when the polymer compound is used for fabrication of a light emitting device. This end group is preferably a group conjugated with the main chain, and includes groups bonding to an aryl group or a monovalent heterocyclic group via a carbon-carbon bond.

The polymer compound of the present invention may be any of a block copolymer, a random copolymer, an alternative copolymer and a graft copolymer and may also be in other form, and is preferably a copolymer obtained by copolymerizing multiple types of raw material monomers.

### <Fractionation precipitation method>

In the present embodiment, the fractionation precipitation method by changing the kind and/or the amount ratio of the good solvent and the poor solvent is preferable, and the fractionation precipitation method by changing the amount ratio of the good solvent and the poor solvent is more preferable, since the operation is simplified. When the polymer compound B, the good solvent for the polymer compound B and the poor solvent for the polymer compound B are used in the fractionation precipitation method, the poor solvent for the polymer compound B may be added to a solution composed of the polymer compound B and the good solvent for the polymer compound B, or a solution composed of the polymer compound B and the good solvent for the polymer compound B may be added to the poor solvent for the polymer compound B.

### <Good solvent for polymer compound B>

The good solvent for the polymer compound B can be selected from various solvents, and in the present specification, it is defined as a solvent having a solubility for the polymer compound B (20°C) of 1 g/100 g or more. Further, the good solvent for the polymer compound B is preferably a solvent having a solubility for the polymer compound B (20°C) of 2 g/100 g or more.

The good solvent for the polymer compound B may be used singly or in combination of two or more, and may also contain water. Of them, aromatic hydrocarbon solvents and ether solvents are preferable, and aromatic hydrocarbon solvents are more preferable. The definitions of the aromatic hydrocarbon solvent and the ether solvent are described below. The aromatic hydrocarbon solvent means a compound which is liquid at 20°C or higher while containing an aromatic hydrocarbon ring as a part of the structure. The ether solvent is a solvent containing a divalent oxygen atom substituted with two carbon atoms, and means a compound that is liquid at 20°C or higher. When an ether and an aromatic hydrocarbon ring are contained simultaneously, it is classified into the aromatic hydrocarbon solvent.

When the good solvent for the polymer compound B is an aromatic hydrocarbon solvent, the number of carbon atoms thereof is preferably 6 to 22, and more preferably 7 to 18. The aromatic hydrocarbon solvent is preferably benzene, toluene, ethylbenzene, propylbenzene, butylbenzene, pentylbenzene, hexylbenzene, xylene, tetralin, methyl benzoate, diphenyl ether, anisole, methylanisole, dimethylanisole, ethyl phenyl ether, butyl phenyl ether, hexylphenyl ether or mesitylene, more preferably toluene, ethylbenzene, xylene, tetralin, anisole, methylanisole or mesitylene, and further preferably toluene, xylene or mesitylene. These aromatic hydrocarbon solvents optionally have a substituent, and the substituent may be any of linear, branched and cyclic. Specific substituents to be optionally carried include, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group, a dodecyl group, a cyclohexyl group, a cyclohexylmethyl group, a cyclohexylethyl group, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and the like.

When the aromatic hydrocarbon solvent has a substituent, the number of the substituent is, for example, 1 to 3.

When the good solvent for the polymer compound B is an ether solvent, the ether solvent may be any of linear, branched and cyclic, and preferable are cyclic ether solvents. The number of carbon atoms of the ether solvent is preferably 4 to 12, and more preferably 4 to 8. The ether solvent is preferably diethyl ether, tetrahydrofuran, butyl methyl ether, methyltetrahydrofuran, dipropyl ether, dibutyl ether, methyl pentyl ether or methyl hexyl ether, more preferably diethyl ether, tetrahydrofuran, butyl methyl ether, methyltetrahydrofuran, dipropyl ether, dibutyl ether, methyl pentyl ether or methyl hexyl ether, and further preferably tetrahydrofuran, butyl methyl ether, dipropyl ether, dibutyl ether or methyl pentyl ether. These ether solvents optionally have a substituent, and the substituent may be any of linear, branched and cyclic. Specific substituents to be optionally carried are the same as the examples of the aromatic hydrocarbon solvent as the good solvent for the polymer compound B. When the ether solvent has a substituent, the number of the substituent is, for example, 1 to 2.

The amount of the good solvent for the polymer compound B is usually preferably 4 to 99 parts by weight, and more preferably 9 to 99 parts by weight, with respect to 1 part by weight of the total amount of the polymer compound B.

### <Poor solvent for polymer compound B>

The poor solvent for the polymer compound B can be selected from various solvents, and in the present specification, it is defined as a solvent having a solubility for the polymer compound B (20°C) of less than 1 g/100 g. Further, the poor solvent for the polymer compound B is preferably one capable of dissolving a low molecular weight compound having low degree of polymerization contained in the polymer compound B. Solvents having a solubility (20°C) for the polymer compound B of less than 0.5 g/100 g are preferable, and those of less than 0.3 g/100 g are more preferable.

As the poor solvent for the polymer compound B, a solvent that is poor for the polymer compound B can be selected and used. The poor solvent for the polymer compound B may be used singly or in combination of two or more, and may also contain water. The poor solvent for the polymer compound B includes, for example, amide solvents, alcohol solvents, ketone solvents, aliphatic hydrocarbon solvents, ester solvents and nitrile solvents, and preferable are alcohol solvents. The amide solvent includes, for example, N-methyl-2-pyrrolidone and the like. The alcohol solvent is preferably an alcohol solvent having 1 to 6 carbon atoms, and more preferably methanol, ethanol or isopropyl alcohol. The ketone solvent is preferably a ketone solvent having 3 to 6 carbon atoms, and more preferably acetone or methyl ethyl ketone. The ester solvent is preferably an ester solvent having 3 to 6 carbon atoms, and more preferably methyl acetate or ethyl acetate. Of the above-mentioned solvents, methanol, ethanol, isopropyl alcohol, acetone and ethyl acetate are preferable, and methanol is more preferable.

The use amount of the poor solvent for the polymer compound B is preferably 25 parts by weight or more, and more preferably 30 parts by weight or more, while it is preferably 150 parts by weight or less, more preferably 100 parts by weight or less, and further preferably 50 parts by weight or less, with respect to 100 parts by weight a solution composed of the polymer compound B and the good solvent for the polymer compound B. When the polymer compound B, the good solvent for the polymer compound B and the poor solvent for the polymer compound B are used, the poor solvent for the polymer compound B may be added after preparing a solution composed only of the polymer compound B and the good solvent for the polymer compound B, or a solution composed only of the polymer compound B and the good solvent for the polymer compound B may be added to the poor solvent for the polymer compound B. An amount of a poor solvent that does not cause liquid-liquid phase-separation may be added in advance to a solution composed of the polymer compound B and the good solvent for the polymer compound B.

The temperature of the solution when adding a poor solvent to a solution composed of the polymer compound B and the good solvent for the polymer compound B or the temperature of the solution when adding a solution composed of the polymer compound B and the good solvent for the polymer compound B to a poor solvent is preferably -30°C or higher, more preferably 0°C or higher, and further preferably 10°C or higher, while it is preferably 60°C or lower, more preferably 40°C or lower, and further preferably 30°C or lower.

The standing time for liquid-liquid phase separation into a phase rich in high molecular weight components and a phase rich in low molecular weight components is usually 10 minutes or more, preferably 1 hour to 48 hours, and more preferably 1 hour to 24 hours. The standing temperature for the separation is preferably -30°C or higher, more preferably 0°C or higher, and further preferably 10°C or higher, while it is preferably 60°C or lower, and more preferably 40°C or lower.

It is important to perform liquid-liquid phase-separation into a phase rich in high molecular weight components and a phase rich in low molecular weight components. If the solid is precipitated, the polymer compound C having small dispersity cannot be obtained. Hence, the fractionation precipitation method is completely different from a step of mixing a poor solvent with a solution containing the polymer compound B dissolved therein to deposit a solid. This liquid-liquid phase-separation operation can be carried out by appropriately controlling the use amounts and the kinds of the good solvent and the poor solvent for the polymer compound B.

In all the liquid-liquid phase-separated layers, all solvents contained in the layers are substantially organic solvents. "Substantially" means that the proportion of organic solvents is, for example, 80% by weight or more, further 90% by weight or more, and particularly 95% by weight or more in all solvents contained in the layers.

Phases separated in the above-described operation are fractionated, to obtain layer containing a phase rich in high molecular weight components. In general, of the separated phases, the phase rich in high molecular weight components tends to separate into the lower layer, and the phase rich in low molecular weight components tends to separate into the upper layer. For this reason, the desired polymer compound C can be obtained usually by separating the lower layer. If necessary, the above-described fractionation operation can be carried out repeatedly. Thereby, the polymer compound C having smaller dispersity can be obtained.

The polymer compound C obtained by fractionation is basically a compound having the constitutional unit (1-1) like the polymer compound B. However, the number-average molecular weight and the weight-average molecular weight are larger and the dispersity is dramatically reduced in the polymer compound C as compared with the polymer compound B, since low molecular weight components are removed by fractionation in the polymer compound C.

The polystyrene-equivalent weight-average molecular weight (Mw) of the polymer compound C is usually 7×10⁴ to 6×10⁶, preferably 7×10⁴ to 5×10⁵, and more preferably 1×10⁵ to 4×10⁵. The dispersity of the polymer compound C is usually 1.1 to 3.0, preferably 1.3 to 2.5, and more preferably 1.4 to 2.2. Though the polystyrene-equivalent number-average molecular weight of the polymer compound C (and polymer compound A) is not particularly restricted, it is preferably within the range of 1×10⁴ to 1×10⁸.

### <Second step>

The second step is not particularly restricted providing it is a method capable of converting the constitutional unit (1-1) into the constitutional unit (1-2), and contains, for example, at least one reaction selected from the group consisting of the Wittig reaction, the Horner-Wadsworth-Emmons reaction, the Peterson reaction, the Johnson reaction, the Julia reaction, a reaction using the Tebbe reagent and a reaction using the Petasis reagent. It is preferably the Wittig reaction, the Horner-Wadsworth-Emmons reaction or the Peterson reaction, more preferably the Wittig reaction or the Peterson reaction, and further preferably the Wittig reaction.

The present step can be carried out, for example, by reacting the constitutional unit (1-1) with a compound having Group R^{A} and Group R^{B} (for example, a phosphorous ylide compound and the like) in a suitable solvent using an optionally selected catalyst. In the embodiment, though the blending ratio of the polymer compound C to the compound having Group R^{A} and Group R^{B} is not particularly restricted, the amount of the compound having Group R^{A} and Group R^{B} can be appropriately set, for example, within the range of 1 to 100 mol, preferably 1.2 to 40 mol, with respect to 1 mol of the constitutional unit (1-1).

Though the solvent usable in the present step is not particularly restricted, examples thereof include the above-described aromatic hydrocarbon solvents, the above-described ether solvents, halogen-containing solvents and the like. These solvents can be used singly or in combination of two or more. The halogen-containing solvent includes, for example, chlorobenzene, dichlorobenzene, chloroform, dichloromethane, dichloroethane and the like.

Though the reaction temperature of the present step is not particularly restricted, it can be appropriately set within the range, for example, of 0 to 100°C, preferably of 0 to 80°C. Further, though also the reaction time of the present step is not particularly restricted, it can be appropriately set within the range, for example, of 2 to 100 hours, preferably of 3 to 24 hours.

### <Purification using adsorbent>

In purifying the polymer compound A using an adsorbent, known adsorbents can be used. The adsorbent includes, for example, silica gel, diatomaceous earth, alumina and the like. Purifications steps using these adsorbents may be combined (for example, a combination of purification using alumina and purification using silica gel, a combination of purification using alumina and purification using diatomaceous earth). Purification of the polymer compound A using an adsorbent can be carried out by contacting a solution containing the polymer compound A and an organic solvent with an adsorbent.

In conducting the above-described purification with an adsorbent, other steps may be provided before and after the step of contacting a solution containing the polymer compound A and an organic solvent with the adsorbent.

Other steps include a step of removing an adsorbent and/or an organic solvent from a mixed liquid containing the polymer compound A, the adsorbent and the organic solvent.

In the step of removing an adsorbent and/or an organic solvent, known methods can be appropriately used. The known method includes, for example, a crystallization method, a method of removing a solvent under reduced pressure and a method of distilling a solvent off with heating. A method in which a solid obtained by a crystallization method is further heated, dried under reduced pressure and taken out in the form of solid is preferred.

The crystallization method can be carried out usually by bringing a poor solvent into contact with a solution containing the polymer compound A and its good solvent. Examples thereof include a method of adding a poor solvent to a solution containing the polymer compound A and its good solvent and stirring the mixture and a method of adding a solution containing the polymer compound A and its good solvent to a poor solvent and stirring the mixture. As the good solvent for the polymer compound A and the poor solvent for the polymer compound A, those mentioned above as the good solvent for the polymer compound B and the poor solvent for the polymer compound B can be used.

### <Light emitting device>

The light emitting device such as an organic electroluminescent device or the like obtained by using the polymer compound A (hereinafter, referred to also as "light emitting device of the present invention") includes, for example, light emitting devices containing the polymer compound A, and light emitting devices in which the polymer compound A is crosslinked intramolecularly, intermolecularly, or in both modes.

The constitution of the light emitting device of the present invention has, for example, electrodes consisting of an anode and a cathode, and a layer obtained by using the polymer compound A disposed between the electrodes.

### [Layer constitution]

The layer obtained by using the polymer compound A is usually one or more of a light emitting layer, a hole transporting layer, a hole injection layer, an electron transporting layer and an electron injection layer, and preferable are a hole transporting layer, a hole injection layer and the like. These layers contain a light emitting material, a hole transporting material, a hole injection material, an electron transporting material and an electron injection material, respectively. These layers can be formed by dissolving a light emitting material, a hole transporting material, a hole injection material, an electron transporting material and an electron injection material in the solvent described above to prepare inks, and using the same method as for fabrication of a film described above using the prepared inks.

The light emitting device has a light emitting layer between an anode and a cathode. The light emitting device of the present invention preferably has at least one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

The materials of the hole transporting layer, the electron transporting layer, the light emitting layer, the hole injection layer and the electron injection layer include the hole transporting material, the electron transporting material, the light emitting material, the hole injection material and the electron injection material described above, respectively, in addition to the polymer compound A. Further, a layer of the polymer compound A may be formed from a composition further containing at least one material selected from the group consisting of a hole transporting material, a hole injection material, an electron transporting material, an electron injection material, a light emitting material, an antioxidant and a solvent.

When the material of the hole transporting layer, the material of the electron transporting layer and the material of the light emitting layer are soluble in a solvent used in forming a layer adjacent to the hole transporting layer, the electron transporting layer and the light emitting layer, respectively, it is preferable that the material has a crosslinkable group for preventing the material from being dissolved in the solvent. After forming each layer using the material having a crosslinkable group, the layer can be insolubilized by crosslinking the crosslinkable group.

The method of forming each of the light emitting layer, the hole transporting layer, the electron transporting layer, the hole injection layer, the electron injection layer and the like in the light emitting device of the present invention includes, for example, a method of vacuum vapor deposition from a powder and a method by film formation from a solution or melted state when a low molecular compound is used, and includes, for example, a method by film formation from a solution or melted state when a polymer compound is used.

The order, the number and the thickness of the layers to be laminated may be adjusted in consideration of the light emission efficiency and the device life.

### [Substrate/electrode]

The substrate in the light emitting device may be a substrate on which an electrode can be formed and which does not chemically change when forming a layer, and is a substrate made of a material such as, for example, glass, plastic, silicon and the like. In the case of an opaque substrate, it is preferable that the electrode farthest from the substrate is transparent or semitransparent.

The material for the anode includes, for example, conductive metal oxides and semitransparent metals, preferably, indium oxide, zinc oxide, tin oxide; conductive compounds such as indium•tin•oxide (ITO), indium•zinc•oxide, and the like; a complex of argentine, palladium and copper (APC); NESA, gold, platinum, silver, and copper.

The material of the cathode includes, for example, metals such as lithium, sodium, potassium, rubidium, cesium, beryllium, magnesium, calcium, strontium, barium, aluminum, zinc, indium and the like; alloys composed of two or more metals described above; alloys composed of one or more metals described above and one or more metals selected from silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The anode and the cathode each may take a laminated structure composed of two or more layers.

The light emitting device of the present invention can be produced, for example, by a method comprising a step of laminating an anode layer, an organic layer and a cathode layer, wherein the method includes a step of thermally hardening a raw material containing the above-described polymer compound A to form at least one of the above-described organic layer. Further, the production method of the light emitting device of the present invention may further contain a step of producing a polymer compound A by the method described above.

### [Application]

In order to obtain planar light emission using a light emitting device, a planar anode and a planar cathode may be arranged so that they overlap with each other. In order to obtain a patterned light emission, there are a method of providing a mask with a patterned window on the surface of a planar light emitting device, a method of forming a layer to be a non-light emitting portion with an extremely large thickness to make it substantially non-luminescent, and a method of forming an anode or a cathode, or both electrodes in a pattern. By forming a pattern by any of the above-mentioned methods and arranging some electrodes so that they can be turned ON/OFF independently, a segment type display device capable of displaying numbers, characters and the like can be obtained. In order to obtain a dot matrix display device, both the anode and the cathode may be formed in stripes and arranged so as to be orthogonal to each other. Partial color display and multi-color display become possible by a method of separately coating a plurality of types of polymer compounds having different emission colors or a method of using a color filter or a fluorescence conversion filter. The dot matrix display device can be passively driven or can be actively driven in combination with TFT or the like. These display devices can be used for displays of computers, televisions, mobile terminals and the like. The planar light emitting device can be suitably used as a planar light source for a backlight of a liquid crystal display device or a planar light source for illumination. If a flexible substrate is used, it can be used also as a curved light source and a curved display device.

### EXAMPLES

The present invention will be illustrated further in detail with reference to examples below, but the present invention is not limited to these examples.

In examples, the polystyrene-equivalent number-average molecular weight (Mn) and the polystyrene-equivalent weight-average molecular weight (Mw) of polymer compounds were determined by size exclusion chromatography (SEC) described below using tetrahydrofuran as the mobile phase.

The polymer compound to be measured was dissolved at a concentration of about 0.05% by weight in tetrahydrofuran, and 10 µL of the solution was injected into SEC. The mobile phase was flowed at a flow rate of 1.0 mL/min. As the column, PLgel MIXED-B (manufactured by Polymer Laboratories Ltd.) was used. As the detector, UV-VIS Detector (manufactured by Tosoh Corp., trade name: UV-8320GPC) was used.

### <Synthesis Example 1> Synthesis of compounds MM1 to MM3

A compound MM1 was synthesized according to a method described in JP-A No. 2011-174062.

A compound MM2 was synthesized according to a method described in JP-T No. 2002-539292.

A compound MM3 was synthesized according to a method described in JP-A No. 2012-519214.

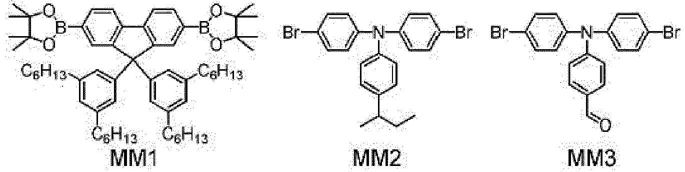

### <Synthesis Example 2> Synthesis of polymer compound 1

An inert gas atmosphere was prepared in a reaction vessel, then, the compound MM1 (11.3 g), the compound MM2 (4.7 g), the compound MM3 (1.10 g), dichlorobis(tris-o-methoxyphenylphosphine)palladium (11 mg) and toluene (160 mL) were added, and the mixture was heated at 85°C. Into the reaction liquid, a 20% by weight tetraethylammonium hydroxide aqueous solution (120 mL) was dropped, and the mixture was refluxed for 2.5 hours. After the reaction, to this were added phenylboronic acid (0.62 g) and dichlorobis(tris-o-methoxyphenylphosphine)palladium (11 mg), and the mixture was refluxed for 4 hours. Thereafter, the resultant reaction liquid was cooled, followed by addition of toluene (100 mL), washed with water, and the resultant solution was dropped into methanol (1800 mL), and the mixture was stirred, then, the resultant precipitate was taken out by filtration and dried, to obtain 8.5 g of a polymer compound 1. The polymer compound 1 had an Mn of 4.95×10⁴, an Mw of 1.71×10⁵, and an Mw/Mn of 3.45.

The polymer compound 1 is a copolymer constituted of a constitutional unit derived from the compound MM1, a constitutional unit derived from the compound MM2 and a constitutional unit derived from the compound MM3 at a molar ratio of 50:40:10, according to the theoretical values calculated from the amounts of the charged raw materials.

### <Example 1>

### (Acquisition of polymer compound 1-2 composed of high molecular weight components of polymer compound 1: first step)

Using 99 parts by weight of toluene with respect to 1 part by weight of the polymer compound 1 (4.20 g), 100 parts by weight of a toluene solution of the polymer compound 1 was prepared, and 32 parts by weight of methanol was dropped into this at room temperature (about 20°C). The resultant solution was stirred, then, allowed to stand still at room temperature for 2 hours to separate into two layers, and the lower layer having higher polystyrene-equivalent weight-average molecular weight was fractionated and diluted with toluene (200 mL). The resultant solution was dropped into methanol (1500 mL), and the mixture was stirred, then, the resultant precipitate was taken out by filtration and dried, to obtain 3.64 g of a polymer compound 1-2. The polymer compound 1-2 had an Mn of 9.96×10⁴, an Mw of 1.93×10⁵, and an Mw/Mn of 1.94.

### (Synthesis of polymer compound 1-3: second step)

An inert gas atmosphere was prepared in a reaction vessel, then, methyltriphenylphosphonium bromide (10.9 g) and toluene (160 mL) were added, and to the resultant suspension was added potassium tert-butoxide (3.41 g). The resultant solution was stirred at room temperature for 3 hours, then, the polymer compound 1-2 (3.64 g) was added, and further, the mixture was stirred at room temperature for 7 hours. The resultant mixed liquid was washed with water three times, and the resultant solution was dropped into methanol (610 mL), and the mixture was stirred. Thereafter, the resultant precipitate was taken out by filtration and dried, to obtain 3.49 g of a polymer compound 1-3. The yield when the polymer compound 1-3 was obtained from the polymer compound 1 (4.20 g) was 83%. The polymer compound 1-3 had an Mn of 9.77×10⁴, an Mw of 1.91×10⁵, and an Mw/Mn of 1.95.

### (Synthesis of polymer compound 1-4)

Using 99 parts by weight of toluene with respect to 1 part by weight of the polymer compound 1-3 (3.49 g), 100 parts by weight of a toluene solution of the polymer compound 1-3 was prepared, and the solution was passed through alumina.

The toluene solution obtained by passing through was dropped into methanol (2000 mL), and the mixture was stirred. Thereafter, the resultant precipitate was taken out by filtration and dried, to obtain 2.66 g of a polymer compound 1-4. The yield when the polymer compound 1-4 was obtained from the polymer compound 1 (4.20 g) was 63%. The polymer compound 1-4 had an Mn of 9.81×10⁴, an Mw of 1.94×10⁵, and an Mw/Mn of 1.97.

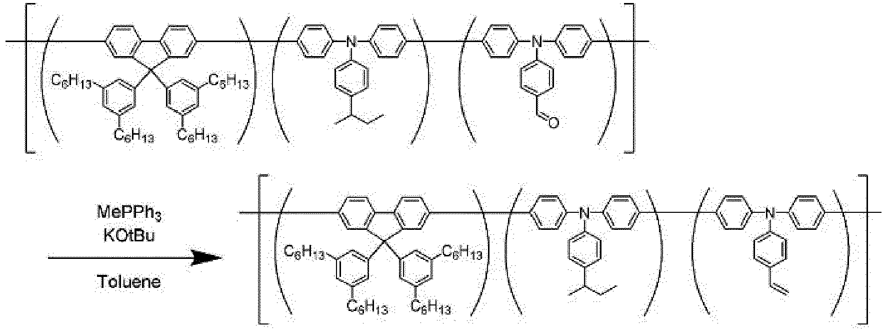

### <Comparative Example 1>

### (Synthesis of polymer compound 2-2: second step)

An inert gas atmosphere was prepared in a reaction vessel, then, methyltriphenylphosphonium bromide (20.2 g) and toluene (300 mL) were added, and to the resultant suspension was added potassium tert-butoxide (6.35 g). After stirring at room temperature for 3 hours, the polymer compound 1 (4.20 g) was added, and further, the mixture was stirred at room temperature for 7 hours. The resultant mixed liquid was washed with water three times, and the resultant solution was dropped into methanol (1200 mL), and the mixture was stirred. Thereafter, the resultant precipitate was taken out by filtration and dried, to obtain 3.96 g of a polymer compound 2-2. The yield when the polymer compound 2-2 was obtained from the polymer compound 1 (4.20 g) was 94%. The polymer compound 2-2 had an Mn of 5.57×10⁴, an Mw of 1.76×10⁵, and an Mw/Mn of 3.16.

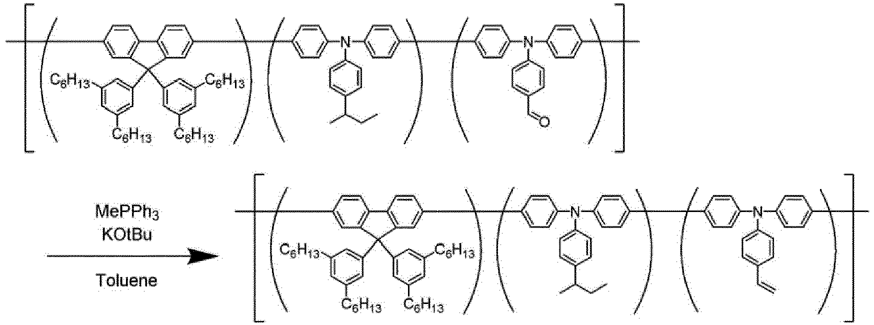

### (Acquisition of polymer compound 2-3 composed of high molecular weight components of polymer compound 2-2: first step)

Using 99 parts by weight of toluene with respect to 1 part by weight of the polymer compound 2-2 (3.96 g), 100 parts by weight of a toluene solution of the polymer compound 2-2 was prepared, and 30 parts by weight of methanol was dropped into this at room temperature. The resultant solution was stirred, then, allowed to stand still at room temperature for 2 hours to separate into two layers, and the lower layer having higher polystyrene-equivalent weight-average molecular weight was fractionated and diluted with toluene (200 mL). The resultant solution was dropped into methanol (1500 mL), and the mixture was stirred, then, the resultant precipitate was taken out by filtration and dried, to obtain 3.12 g of a polymer compound 2-3. The yield when the polymer compound 2-3 was obtained from the polymer compound 1 (4.20 g) was 74%. The polymer compound 2-3 had an Mn of 9.75×10⁴, an Mw of 1.91×10⁵, and an Mw/Mn of 1.96.

### (Synthesis of polymer compound 2-4)

Using 99 parts by weight of toluene with respect to 1 part by weight of the polymer compound 2-3 (3.12 g), 100 parts by weight of a toluene solution of the polymer compound 2-3 was prepared, and the solution was passed through alumina.

The toluene solution obtained by passing through was dropped into methanol (1400 mL), and the mixture was stirred. Thereafter, the resultant precipitate was taken out by filtration and dried, to obtain 2.34 g of a polymer compound 2-4. The yield when the polymer compound 2-4 was obtained from the polymer compound 1 (4.20 g) was 56%. The polymer compound 2-4 had an Mn of 9.75×10⁴, an Mw of 1.94×10⁵, and an Mw/Mn of 1.98.

### <Synthesis Example 3> Synthesis of compounds MM4 to MM7

A compound MM4 was synthesized according to a method described in International Publication WO2016/031639.

A compound MM5 was synthesized according to a method described in JP-A No. 2011-174062.

A compound MM6 was synthesized according to a method described in JP-A No. 2004-143419.

A compound MM7 was purchased from Sigma-Aldrich.

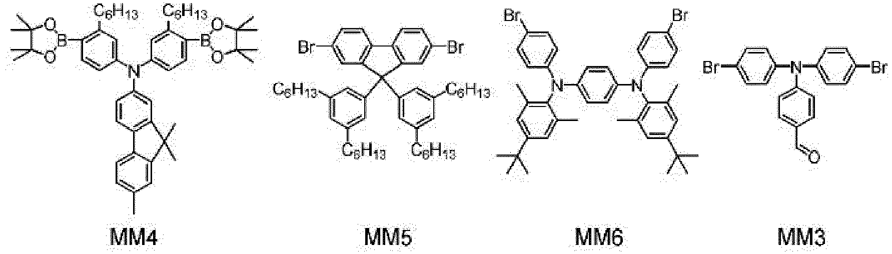

### <Synthesis Example 4> Synthesis of polymer compound 3

An inert gas atmosphere was prepared in a reaction vessel, then, the compound MM4 (8.6 g), the compound MM5 (5.3 g), the compound MM6 (1.6 g), the compound MM3 (0.94 g), dichlorobis(tris-o-methoxyphenylphosphine)palladium (9.6 mg) and toluene (150 mL) were added, and the mixture was heated at 85°C. Into the reaction liquid, a 20% by weight tetraethylammonium hydroxide aqueous solution (120 mL) was dropped, and the mixture was refluxed for 3.5 hours. After the reaction, to this were added phenylboronic acid (0.54 g) and dichlorobis(tris-o-methoxyphenylphosphine)palladium (9.6 mg), and the mixture was refluxed for 4 hours. Thereafter, the resultant reaction liquid was cooled, followed by addition of toluene (100 mL), washed with water, and the resultant solution was dropped into methanol (2000 mL), and the mixture was stirred, then, the resultant precipitate was taken out by filtration and dried, to obtain 9.6 g of a polymer compound 3. The polymer compound 3 had an Mn of 2.71×10⁴, an Mw of 8.31×10⁴, and an Mw/Mn of 3.07.

The polymer compound 3 is a copolymer constituted of a constitutional unit derived from the compound MM4, a constitutional unit derived from the compound MM5, a constitutional unit derived from the compound MM6 and a constitutional unit derived from the compound MM3 at a molar ratio of 50:30:10:10, according to the theoretical values calculated from the amounts of the charged raw materials.

### <Example 2>

### (Acquisition of polymer compound 3-2 composed of high molecular weight components of polymer compound 3: first step)

Using 99 parts by weight of toluene with respect to 1 part by weight of the polymer compound 3 (4.80 g)obtained in Synthesis Example 4, 100 parts by weight of a toluene solution of the polymer compound 3 was prepared, and 40 parts by weight of methanol was dropped into this at room temperature (about 20°C).

The resultant solution was stirred, then, allowed to stand still at room temperature for 3 hours to separate into two layers, and the lower layer having higher polystyrene-equivalent weight-average molecular weight was fractionated and diluted with toluene (200 mL).

The resultant solution was dropped into methanol (1500 mL), and the mixture was stirred, then, the resultant precipitate was taken out by filtration and dried, to obtain 4.16 g of a polymer compound 3-2. The polymer compound 3-2 had an Mn of 5.57×10⁴, an Mw of 1.01×10⁵, and an Mw/Mn of 1.81.

### (Synthesis of polymer compound 3-3: second step)

An inert gas atmosphere was prepared in a reaction vessel, then, methyltriphenylphosphonium bromide (10.8 g) and toluene (108 mL) were added, and to the resultant suspension was added potassium tert-butoxide (3.38 g). The resultant solution was stirred at room temperature for 2.5 hours, then, the polymer compound 3-2 (4.16 g) was added, and further, the mixture was stirred at room temperature for 7 hours. The resultant mixed liquid was washed with water three times, and the resultant solution was dropped into methanol (690 mL), and the mixture was stirred. Thereafter, the resultant precipitate was taken out by filtration and dried, to obtain 3.91 g of a polymer compound 3-3. The yield when the polymer compound 3-3 was obtained from the polymer compound 3 (4.80 g) was 81%. The polymer compound 3-3 had an Mn of 5.51×10⁴, an Mw of 9.88×10⁴, and an Mw/Mn of 1.79.

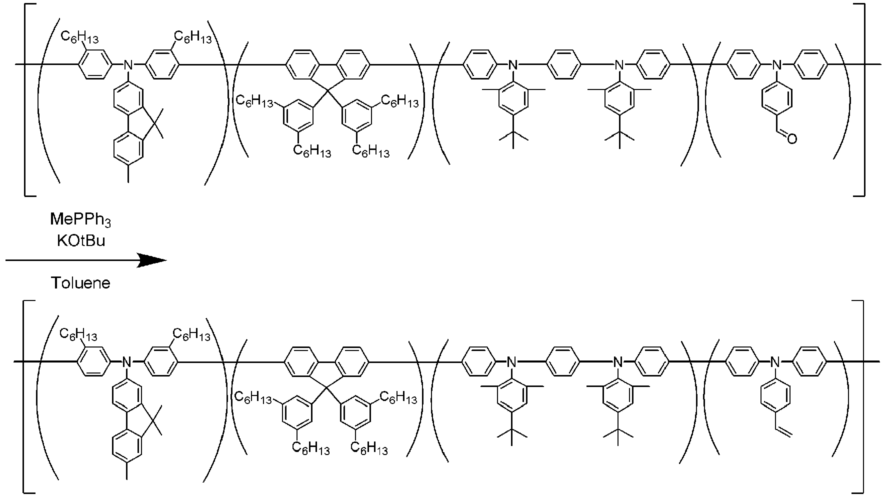

### (Synthesis of polymer compound 3-4)

Using 99 parts by weight of toluene with respect to 1 part by weight of the polymer compound 3-3 (3.91 g), 100 parts by weight of a toluene solution of the polymer compound 3-3 was prepared, and this was passed through a mixture of alumina and silica gel. The toluene solution obtained by passing through was dropped into methanol (2000 mL), and the mixture was stirred. Thereafter, the resultant precipitate was taken out by filtration and dried, to obtain 3.30 g of a polymer compound 3-4. The yield when the polymer compound 3-4 was obtained from the polymer compound 3 (4.80 g) was 69%. The polymer compound 3-4 had an Mn of 5.10×10⁴, an Mw of 9.39×10⁴, and an Mw/Mn of 1.84.

### <Comparative Example 2>

### (Synthesis of polymer compound 4-2: second step)

An inert gas atmosphere was prepared in a reaction vessel, then, methyltriphenylphosphonium bromide (12.4 g) and toluene (124 mL) were added, and to the resultant suspension was added potassium tert-butoxide (3.90 g). After stirring at room temperature for 2.5 hours, the polymer compound 3 (4.80 g) obtained in Synthesis Example 4 was added, and further, the mixture was stirred at room temperature for 7 hours. The resultant mixed liquid was washed with water three times, and the resultant solution was dropped into methanol (800 mL), and the mixture was stirred. Thereafter, the resultant precipitate was taken out by filtration and dried, to obtain 4.49 g of a polymer compound 4-2. The yield when the polymer compound 4-2 was obtained from the polymer compound 3 (4.80 g) was 94%. The polymer compound 4-2 had an Mn of 2.68×10⁴, an Mw of 8.10×10⁴, and an Mw/Mn of 3.03.

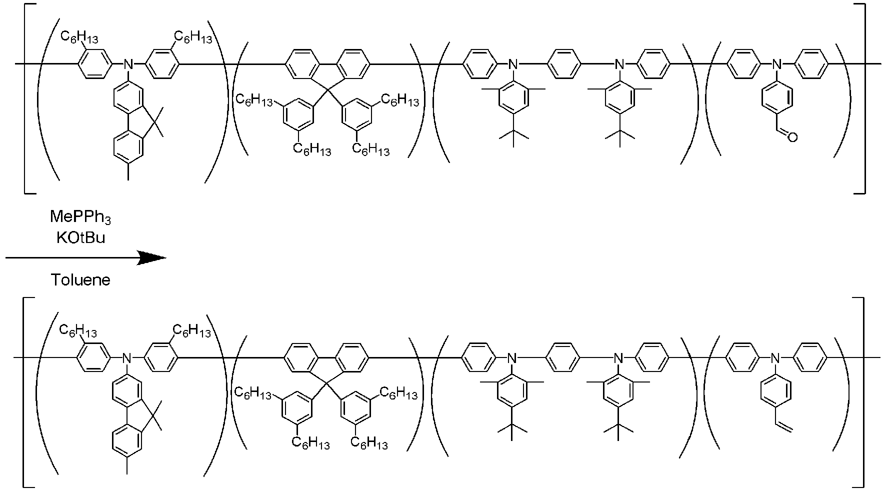

### (Acquisition of polymer compound 4-3 composed of high molecular weight components of polymer compound 4-2: first step)

Using 99 parts by weight of toluene with respect to 1 part by weight of the polymer compound 4-2 (4.49 g), 100 parts by weight of a toluene solution of the polymer compound 4-2 was prepared, and 36 parts by weight of methanol was dropped into this at room temperature. The resultant solution was stirred, then, allowed to stand still at room temperature for 2 hours to separate into two layers, and the lower layer having higher polystyrene-equivalent weight-average molecular weight was fractionated and diluted with toluene (200 mL). The resultant solution was dropped into methanol (2000 mL), and the mixture was stirred, then, the resultant precipitate was taken out by filtration and dried, to obtain 3.38 g of a polymer compound 4-3. The yield when the polymer compound 4-3 was obtained from the polymer compound 3 (4.80 g) was 70%. The polymer compound 4-3 had an Mn of 5.47×10⁴, an Mw of 1.02×10⁵, and an Mw/Mn of 1.86.

### (Synthesis of polymer compound 4-4)

Using 99 parts by weight of toluene with respect to 1 part by weight of the polymer compound 4-3 (3.39 g), 100 parts by weight of a toluene solution of the polymer compound 4-3 was prepared, and this was passed through a mixture of alumina and silica gel. The toluene solution obtained by passing through was dropped into methanol (2000 mL), and the mixture was stirred. Thereafter, the resultant precipitate was taken out by filtration and dried, to obtain 2.91 g of a polymer compound 4-4. The yield when the polymer compound 4-4 was obtained from the polymer compound 3 (4.80 g) was 61%. The polymer compound 4-4 had an Mn of 4.99×10⁴, an Mw of 9.70×10⁴, and an Mw/Mn of 1.94.

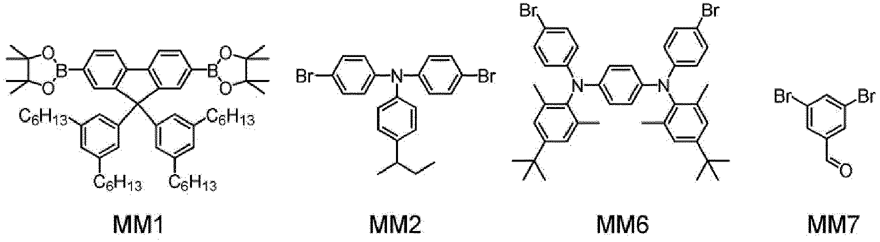

### <Synthesis Example 5> Synthesis of polymer compound 5

An inert gas atmosphere was prepared in a reaction vessel, then, the compound MM1 (10.9 g), the compound MM2 (3.4 g), the compound MM6 (1.8 g), the compound MM7 (0.65 g), dichlorobis(tris-o-methoxyphenylphosphine)palladium (11 mg) and toluene (140 mL) were added, and the mixture was heated at 85°C. Into the reaction liquid, a 20% by weight tetraethylammonium hydroxide aqueous solution (120 mL) was dropped, and the mixture was refluxed for 2 hours. After the reaction, to this were added phenylboronic acid (0.62 g) and dichlorobis(tris-o-methoxyphenylphosphine)palladium (11 mg), and the mixture was refluxed for 6 hours. Thereafter, the resultant reaction liquid was cooled, followed by addition of toluene (100 mL), washed with water, and the resultant solution was dropped into methanol (1500 mL), and the mixture was stirred, then, the resultant precipitate was taken out by filtration and dried, to obtain 10.3 g of a polymer compound 5. The polymer compound 5 had an Mn of 3.26×10⁴, an Mw of 1.02×10⁵, and an Mw/Mn of 3.13.

The polymer compound 5 is a copolymer constituted of a constitutional unit derived from the compound MM1, a constitutional unit derived from the compound MM2, a constitutional unit derived from the compound MM6 and a constitutional unit derived from the compound MM7 at a molar ratio of 50:30:10:10, according to the theoretical values calculated from the amounts of the charged raw materials.

### <Example 3>

### (Acquisition of polymer compound 5-2 composed of high molecular weight components of polymer compound 5: first step)

Using 99 parts by weight of toluene with respect to 1 part by weight of the polymer compound 5 (5.10 g), 100 parts by weight of a toluene solution of the polymer compound 5 was prepared, and 32 parts by weight of methanol was dropped into this at room temperature (about 20°C). The resultant solution was stirred, then, allowed to stand still at room temperature for 6 hours to separate into two layers, and the lower layer having higher polystyrene-equivalent weight-average molecular weight was fractionated and diluted with toluene (200 mL). The resultant solution was dropped into methanol (1500 mL), and the mixture was stirred, then, the resultant precipitate was taken out by filtration and dried, to obtain 3.45 g of a polymer compound 5-2. The polymer compound 5-2 had an Mn of 6.21×10⁴, an Mw of 1.24×10⁵, and an Mw/Mn of 2.03.

### (Synthesis of polymer compound 5-3: second step)

An inert gas atmosphere was prepared in a reaction vessel, then, methyltriphenylphosphonium bromide (10.2 g) and toluene (102 mL) were added, and to the resultant suspension was added potassium tert-butoxide (3.19 g). The resultant solution was stirred at room temperature for 2.5 hours, then, the polymer compound 5-2 (3.45 g) was added, and further, the mixture was stirred at room temperature for 7 hours. The resultant mixed liquid was washed with water three times, and the resultant solution was dropped into methanol (650 mL), and the mixture was stirred. Thereafter, the resultant precipitate was taken out by filtration and dried, to obtain 2.95 g of a polymer compound 5-3. The yield when the polymer compound 5-3 was obtained from the polymer compound 5 (5.10 g) was 58%. The polymer compound 5-3 had an Mn of 6.10×10⁴, an Mw of 1.26×10⁵, and an Mw/Mn of 2.07.

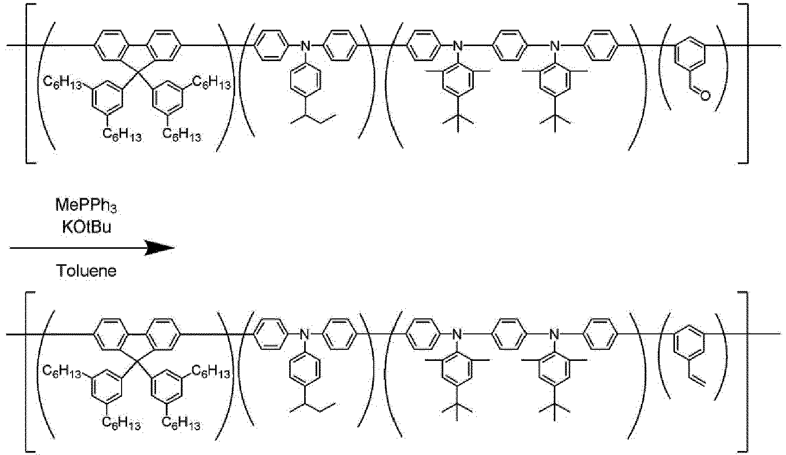

### (Synthesis of polymer compound 5-4)

Using 99 parts by weight of toluene with respect to 1 part by weight of the polymer compound 5-3 (2.95 g), 100 parts by weight of a toluene solution of the polymer compound 5-3 was prepared, and this was passed through a mixture of alumina and diatomaceous earth. The toluene solution obtained by passing through was dropped into methanol (2000 mL), and the mixture was stirred. Thereafter, the resultant precipitate was taken out by filtration and dried, to obtain 2.40 g of a polymer compound 5-4. The yield when the polymer compound 5-4 was obtained from the polymer compound 5 (5.10 g) was 47%. The polymer compound 5-4 had an Mn of 6.30x10⁴, an Mw of 1.25x10⁵, and an Mw/Mn of 1.98.

### <Comparative Example 3>

### (Synthesis of polymer compound 6-2: second step)

An inert gas atmosphere was prepared in a reaction vessel, then, methyltriphenylphosphonium bromide (15.1 g) and toluene (151 mL) were added, and to the resultant suspension was added potassium tert-butoxide (4.74 g). After stirring at room temperature for 2.5 hours, the polymer compound 5 (5.10 g) was added, and further, the mixture was stirred at room temperature for 7 hours. The resultant mixed liquid was washed with water three times, and the resultant solution was dropped into methanol (1000 mL), and the mixture was stirred. Thereafter, the resultant precipitate was taken out by filtration and dried, to obtain 4.44 g of a polymer compound 6-2. The yield when the polymer compound 6-2 was obtained from the polymer compound 5 (5.10 g) was 87%. The polymer compound 6-2 had an Mn of 2.33×10⁴, an Mw of 8.48×10⁴, and an Mw/Mn of 3.64.

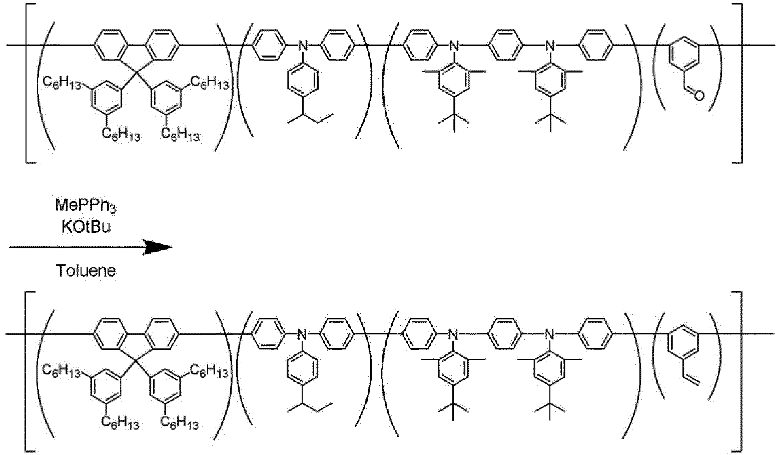

### (Acquisition of polymer compound 6-3 composed of high molecular weight components of polymer compound 6-2: first step)

Using 99 parts by weight of toluene with respect to 1 part by weight of the polymer compound 6-2 (4.49 g), 100 parts by weight of a toluene solution of the polymer compound 6-2 was prepared, and 33 parts by weight of methanol was dropped into this at room temperature. The resultant solution was stirred, then, allowed to stand still at room temperature for 13 hours to separate into two layers, and the lower layer having higher polystyrene-equivalent weight-average molecular weight was fractionated and diluted with toluene (200 mL). The resultant solution was dropped into methanol (1500 mL), and the mixture was stirred, then, the resultant precipitate was taken out by filtration and dried, to obtain 2.69 g of a polymer compound 6-3. The yield when the polymer compound 6-3 was obtained from the polymer compound 5 (5.10 g) was 53%. The polymer compound 6-3 had an Mn of 5.50×10⁴, an Mw of 1.18×10⁵, and an Mw/Mn of 2.15.

### (Synthesis of polymer compound 6-4)

Using 99 parts by weight of toluene with respect to 1 part by weight of the polymer compound 6-3 (2.69 g), 100 parts by weight of a toluene solution of the polymer compound 6-3 was prepared, and this was passed through a mixture of alumina and diatomaceous earth. The toluene solution obtained by passing through was dropped into methanol (1700 mL), and the mixture was stirred. Thereafter, the resultant precipitate was taken out by filtration and dried, to obtain 2.21 g of a polymer compound 6-4. The yield when the polymer compound 6-4 was obtained from the polymer compound 5 (5.10 g) was 43%. The polymer compound 6-4 had an Mn of 5.63×10⁴, an Mw of 1.17×10⁵, and an Mw/Mn of 2.08.

### <Synthesis of polymer compound E1>

An inert gas atmosphere was prepared in a reaction vessel, then, 2,7-dibromo-9,9-di(octyl)fluorene (9.0 g), N,N'-bis(4-bromophenyl)-N,N'-bis(4-tert-butyl-2,6-dimethyl phenyl)1,4-phenylenediamine (1.3 g), 2,7-bis(4,4,5,5-tetramethyl-1,3,2-dioxabororan-2-yl)-9,9-di(4-hexylphenyl)fluorene (13.4 g), tetraethylammonium hydroxide (43.0g), palladium acetate (8 mg), tri(2-methoxyphenyl)phosphine (0.05g) and toluene (200 mL) were mixed, and the resultant mixture was stirred with heating at 90°C for 8 hours. Then, phenylboronic acid (0.22 g) was added, and the resultant mixture was stirred for 14 hours. After being left to cool, then, the aqueous layer was removed, a sodium diethyldithiocarbamate aqueous solution was added and the mixture was stirred, then, the aqueous layer was removed, and the organic layer was washed with water and a 3% by weight acetic acid water. The organic layer was poured into methanol to precipitate a solid, then, the solid was taken out by filtration and dissolved again in toluene, and the solution was passed through a mixture of silica gel and alumina. The eluted toluene solution containing a solid was recovered, and the above-described recovered toluene solution was poured into methanol, to precipitate a solid. The precipitated solid was vacuum-dried at 50°C, to obtain polymer compound E1 (12.5 g). The resultant polymer compound E1 has a polystyrene-equivalent weight-average molecular weight of 3.1×10⁵.

### <Example D1> Fabrication and evaluation of light emitting device D1

### [Formation of light emitting device D1]

### (Formation of anode and hole injection layer)

An ITO film was attached with a thickness of 45 nm to a glass substrate by a sputtering method, to form an anode. On the anode, a hole injection material ND-3202 (manufactured by Nissan Chemical Corporation) was spin-coated to form a film with a thickness of 35 nm. Under an air atmosphere, the film was heated on a hot plate at 240°C for 15 minutes, to form a hole injection layer.

### (Formation D1 of hole transporting layer)

The polymer compound 1-4 was dissolved in xylene at a concentration of 0.6% by weight. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

The polymer compound E1 was dissolved in xylene at a concentration of 1.0% by weight. The resultant xylene solution was spin-coated on the hole transporting layer to form a film with a thickness of 60 nm, and the film was heated at 150°C for 10 minutes under a nitrogen gas atmosphere, to form a light emitting layer.

### (Formation of cathode)

The substrate carrying the light emitting layer formed thereon was placed in a vapor deposition machine, and the inner pressure thereof was reduced to 1.0×10⁻⁴ Pa or less, then, sodium fluoride was vapor-deposited with a thickness of about 3.5 nm on the light emitting layer, then, aluminum was vapor-deposited with a thickness of about 80 nm on the sodium fluoride layer, as cathodes. After the vapor deposition, sealing was performed using a glass substrate, to fabricate a light emitting device D1.

### [Evaluation]

Voltage was applied to the light emitting device D1, to observe EL light emission. The CIE chromaticity coodcinate (x, y) at 1000 cd/m² was (0.147, 0.115).

### <Example D2> Fabrication and evaluation of light emitting device D2

### [Formation of light emitting device D2]

A light emitting device D2 was fabricated in the same manner as in Example D1, except that (Formation D1 of hole transporting layer) in Example D1 was changed to (Formation D2 of hole transporting layer) described below.

### (Formation D2 of hole transporting layer)

The polymer compound 3-4 was dissolved in xylene at a concentration of 0.6% by weight. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### [Evaluation]

Voltage was applied to the light emitting device D2, to observe EL light emission. The CIE chromaticity coordinate (x, y) at 1000 cd/m² was (0.148, 0.112).

### <Example D3> Fabrication and evaluation of light emitting device D3

### [Formation of light emitting device D3]

A light emitting device D3 was fabricated in the same manner as in Example D1, except that (Formation D1 of hole transporting layer) in Example D1 was changed to (Formation D3 of hole transporting layer) described below.

### (Formation D3 of hole transporting layer)

The polymer compound 5-4 was dissolved in xylene at a concentration of 0.6% by weight. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### [Evaluation]

Voltage was applied to the light emitting device D3, to observe EL light emission. The CIE chromaticity coordinate (x, y) at 1000 cd/m² was (0.148, 0.114).

### Industrial Applicability

According to the present invention, a polymer compound production method which is capable of improving yield while lowering the dispersity of the molecular weight can be provided.

## Claims

1. A method of producing a polymer compound A containing a constitutional unit (1-2) having a group obtained by removing one or more hydrogen atoms present on Ar¹ from a compound represented by the formula [1-2], comprising
a first step of separating high molecular weight components contained in a polymer compound B, by a fractionation precipitation method, from the polymer compound B containing a constitutional unit (1-1) having a group obtained by removing one or more hydrogen atoms present on Ar¹ from a compound represented by the formula [1-1], to obtain a polymer compound C composed of the high molecular weight components, and
a second step of converting said constitutional unit (1-1) contained in said polymer compound C obtained by said first step into said constitutional unit (1-2), to obtain said polymer compound A: 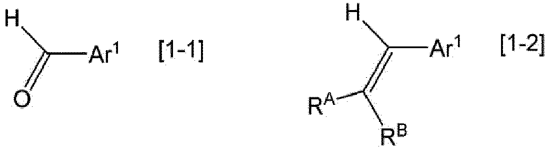
wherein,
Ar¹ represents an aryl group optionally having a substituent or a monovalent heterocyclic group optionally having a substituent,
R^{A} and R^{B} each independently represent a hydrogen atom, an alkyl group, a cycloalkyl group, an aryl group or a monovalent heterocyclic group, and these groups optionally have a substituent.

2. The production method according to Claim 1,
wherein said polymer compound B, a good solvent for said polymer compound B and a poor solvent for said polymer compound B are used in said fractionation precipitation method.

3. The production method according to Claim 1 or 2,
wherein said polymer compound A, said polymer compound B and said polymer compound C further contain a constitutional unit represented by the formula (X): 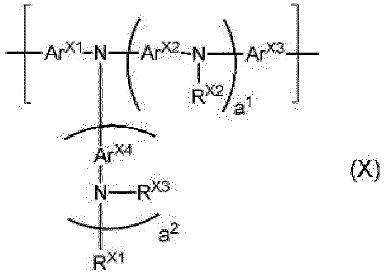 wherein,
a¹ and a² each independently represent an integer of 0 or more,
Ar^{x1} and Ar^{x3} each independently represent an arylene group or a divalent heterocyclic group, and these groups optionally have a substituent,
Ar^{x2} and Ar^{x4} each independently represent an arylene group, a divalent heterocyclic group, or a divalent group in which at least one arylene group and at least one divalent heterocyclic group are bonded directly, and these groups optionally have a substituent, when a plurality of Ar^{x2} and Ar^{x4} are present, they may be the same or different at each occurrence,
R^{X1}, R^{X2} and R^{X3} each independently represent a hydrogen atom, an alkyl group, a cycloalkyl group, an aryl group or a monovalent heterocyclic group, and these groups optionally have a substituent, when a plurality of R^{X2} and R^{X3} are present, they may be the same or different at each occurrence.

4. The production method according to any one of Claims 1 to 3, wherein said constitutional unit (1-1) is a constitutional unit represented by the formula (2-1), and said constitutional unit (1-2) is a constitutional unit represented by the formula (2-2): 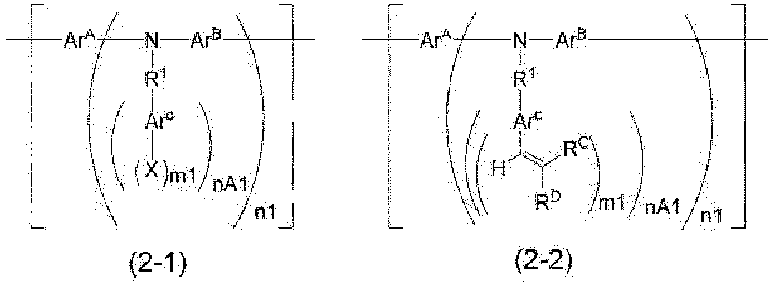 wherein,
n1 and nA1 each independently represent an integer of 1 to 3, when a plurality of nA1 are present, they may be the same or different,
m1 represents an integer of 1 or more, when a plurality of m1 are present, they may be the same or different,
X represents a formyl group, a hydrogen atom, an alkyl group, a cycloalkyl group, an aryl group or a monovalent heterocyclic group, when X is an alkyl group, a cycloalkyl group, an aryl group or a monovalent heterocyclic group, these groups optionally have a substituent, when a plurality of X are present, they may be the same or different, however, at least one X is a formyl group,
Ar^{A} and Ar^{B} each independently represent an arylene group or a divalent heterocyclic group, and these groups optionally have a substituent, Ar^{c} represents an aromatic hydrocarbon ring or a heterocyclic group, and these groups optionally have a substituent, when a plurality of Ar^{B} and Ar^{C} are present, they may be the same or different at each occurrence, at least two or more of Ar^{A}, Ar^{B} and Ar^{C} may be combined together to form a ring,
R¹ represents a single bond or an aliphatic hydrocarbon group, and these groups optionally have a substituent, when a plurality of R¹ are present, they may be the same or different, however, nA1 is 1 when R¹ is a single bond,
R^{C} and R^{D} each independently represent a hydrogen atom, an alkyl group, a cycloalkyl group, an aryl group or a monovalent heterocyclic group, and these groups optionally have a substituent, when a plurality of R^{C} and R^{D} are present, they may be the same or different at each occurrence.

5. The production method according to any one of Claims 1 to 3, wherein said constitutional unit (1-1) is a constitutional unit represented by the formula (3-1), and said constitutional unit (1-2) is a constitutional unit represented by the formula (3-2): 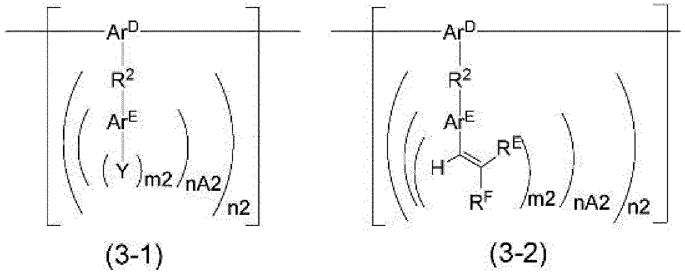 wherein,
n2 and nA2 each independently represent an integer of 1 to 3, when a plurality of nA2 are present, they may be the same or different,
m2 represents an integer of 1 or more, when a plurality of m2 are present, they may be the same or different,
Y represents a formyl group, a hydrogen atom, an alkyl group, a cycloalkyl group, an aryl group or a monovalent heterocyclic group, when Y is an alkyl group, a cycloalkyl group, an aryl group or a monovalent heterocyclic group, these groups optionally have a substituent, when a plurality of Y are present, they may be the same or different, however, at least one Y is a formyl group,
Ar^{D} represents an aromatic hydrocarbon ring or a heterocyclic group, and these groups optionally have a substituent,
Ar^{E} represents an aromatic hydrocarbon ring or a heterocyclic group, and these groups optionally have a substituent, when a plurality of Ar^{E} are present, they may be the same or different,
R² represents a single bond or an aliphatic hydrocarbon group, and these groups optionally have a substituent, when a plurality of R² are present, they may be the same or different,
R^{E} and R^{F} each independently represent a hydrogen atom, an alkyl group, a cycloalkyl group, an aryl group or a monovalent heterocyclic group, and these groups optionally have a substituent, when a plurality of R^{E} and R^{F} are present, they may be the same or different at each occurrence.

6. The production method according to any one of Claims 1 to 3, wherein said constitutional unit (1-1) is a constitutional unit represented by the formula (4-1), and said constitutional unit (1-2) is a constitutional unit represented by the formula (4-2): 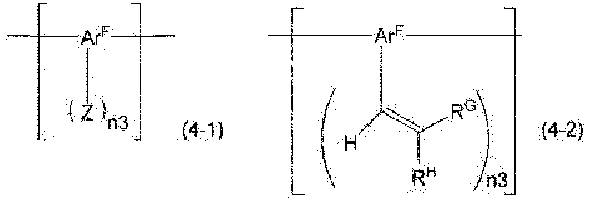 wherein,
n3 represents an integer of 1 to 3,
Z represents a formyl group, a hydrogen atom, an alkyl group, a cycloalkyl group, an aryl group or a monovalent heterocyclic group, when Z is an alkyl group, a cycloalkyl group, an aryl group or a monovalent heterocyclic group, these groups optionally have a substituent, when a plurality of Z are present, they may be the same or different, however, at least one Z is a formyl group,
Ar^{F} represents an aromatic hydrocarbon ring or a heterocyclic group, and these groups optionally have a substituent,
R^{G} and R^{H} each independently represent a hydrogen atom, an alkyl group, a cycloalkyl group, an aryl group or a monovalent heterocyclic group, and these groups optionally have a substituent, when a plurality of R^{G} and R^{H} are present, they may be the same or different at each occurrence.

7. The production method according to any one of Claims 1 to 6, comprising a step of purifying the resultant polymer compound A using an adsorbent, after said second step.

8. A light emitting device production method comprising a step of laminating an anode layer, organic layers and a cathode layer, wherein the method comprises a step of thermally hardening a raw material containing the polymer compound A obtained by using the production method as described in any one of Claims 1 to 7 to form at least one of said organic layers.
